# EUROPÄISCHE PATENTSCHRIFT

(11) **EP 3 935 673 B1**
(45) Veröffentlichungstag und Bekanntmachung des Hinweises auf die Patenterteilung: **12.07.2023**
(21) Anmeldenummer: 20711072.7
(22) Anmeldetag: 04.03.2020
(51) Int. Cl.: H10N 30/50, H02N 2/00, H02N 2/02

(54) **VERFAHREN ZUM BETREIBEN EINES ELEKTROMECHANISCHEN ELEMENTS, AKTOR, ANTRIEBSVORRICHTUNG UND MOTOR**
METHOD FOR OPERATING AN ELECTROMECHANICAL ELEMENT, ACTUATOR, DRIVE DEVICE AND MOTOR
PROCÉDÉ POUR FAIRE FONCTIONNER UN ÉLÉMENT ÉLECTROMÉCANIQUE, ACTIONNEUR, DISPOSITIF D'ENTRAÎNEMENT ET MOTEUR

(30) Priorität: 06.03.2019 DE 102019001579
(43) Veröffentlichungstag der Anmeldung: 12.01.2022
(73) Patentinhaber: Physik Instrumente (PI) GmbH & Co. KG, 76228 Karlsruhe (DE)
(72) Erfinder: KOC, Burhanettin, 76275 Ettlingen (DE)
(74) Vertreter: Keller Schneider Patentanwaltsgesellschaft mbH
(86) Internationale Anmeldenummer: PCT/EP2020/055668
(87) Internationale Veröffentlichungsnummer: WO 2020/178320

(56) Entgegenhaltungen:
- WO-A2-2007/020177
- DE-B3-102019 001 579
- US-A1- 2008 094 677
- US-A1- 2012 293 577

## Beschreibung

Die Erfindung betrifft ein Verfahren zum Betreiben eines elektromechanischen Elements, einen Aktor, eine Antriebsvorrichtung mit einem Aktor und einen Motor mit einer Antriebsvorrichtung und einem anzutreibenden Element.

Die JP 2012 147510 A offenbart eine Antriebsvorrichtung mit einem stationär gelagerten ersten Aktor und einem zweiten Aktor, der auf dem ersten Aktor gelegen und zum Kontakt mit einem anzutreibenden Element vorgesehen ist. Die Deformationsrichtungen der beiden Aktoren verlaufen senkrecht zueinander. Der erste Aktor wird mit einer symmetrischen Dreiecksspannung beaufschlagt. Im ansteigenden oder im abfallenden Bereich wird der zweite Aktor mit einer hochfrequenten Spannung beaufschlagt, um mit den dadurch erzeugten Vibrationen in dem zweiten Aktor bzw. an der Grenzfläche zwischen zweitem Aktor und anzutreibendem Element in diesem zeitlichen Bereich eine Herabsetzung der Reibungskoeffizienten zwischen zweitem Aktor und anzutreibendem Element zu bewirken, so dass in dem betreffenden zeitlichen Bereich eine gleitende Relativbewegung zwischen dem zweiten Aktor und dem anzutreibenden Element realisiert werden kann (Slip-Phase), während in dem jeweils anderen zeitlichen Bereich der Dreiecksspannung, in welchem der zweite Aktor nicht mit einer hochfrequenten Spannung beaufschlagt wird, der Reibungskoeffizient zwischen dem zweiten Aktor und dem anzutreibenden Element nicht herabgesetzt ist und derart bemessen ist, dass aufgrund der herrschenden Reibung (d.h. Haftreibung) das anzutreibende Element der durch den ersten Aktor hervorgerufenen Bewegung des zweiten Aktors folgt (Stick-Phase).

In der US 2012/293577 A1, der US 2008/094677 A1 und DE 10 2019 001579 B3 ist jeweils ein Verfahren zum Betreiben eines elektromechanischen Elements beschrieben.

Aus der WO 2007/020177 A2 ist ein piezoelektrischer Aktor für einen Ultraschallaktor bekannt.

Aufgabe der Erfindung ist, ein Verfahren zum Betreiben eines elektromechanischen Elements, einen Aktor, eine Antriebsvorrichtung mit einem solchen Aktor und einen Motor mit einer solchen Antriebsvorrichtung bereitzustellen, mit der bzw. mit dem ein anzutreibendes Element mit einer vorbestimmten Genauigkeit positionierbar ist. Diese Aufgabe wird mit den Merkmalen der unabhängigen Ansprüche gelöst. Weitere Ausführungsformen sind in den jeweils auf diese rückbezogenen Unteransprüche angegeben.

Nach der Erfindung ist ein Verfahren vorgesehen, das die folgenden Schritte aufweist:
durch Ansteuern eines ersten durch eine elektrische Spannung deformierbaren Ansteuerabschnitts mit einem ersten Spannungssignal Erzeugung von Stellbewegungen eines an dem elektromechanischen Element angeordneten Friktionselements, das zu einem Friktionskontakt mit einem anzutreibenden Element vorgesehen ist, wobei das erste Spannungssignal eine Mehrzahl von sich im zeitlichen Verlauf einander abwechselnden betragsmäßig ansteigenden Signalflanken und betragsmäßig abfallenden Signalflanken aufweist, wobei nach einer ansteigenden Signalflanke und vor einer darauf folgenden abfallenden Signalflanke, oder umgekehrt, ein Signal-Zwischenabschnitt mit einem von Null abweichenden Zeitintervall gelegen ist, der sich im zeitlichen Verlauf von der Form der Signalflanken unterscheidet und vorzugsweise eine zeitabhängige Steigung aufweist,
Ansteuern eines zweiten durch eine elektrische Spannung deformierbaren Ansteuerabschnitts mit einem zweiten Spannungssignal, der einen Signalabschnitt aufweist, dessen Frequenz im Vergleich zum ersten Spannungssignal um einen Faktor von wenigstens 10 mal höher ist und zeitlich innerhalb des Zeitintervalls t_{z} eines Signal-Zwischenabschnitts des ersten Spannungssignals beginnt und sich zumindest teilweise über die an diesen jeweils zeitlich anschließende Signalflanke erstreckt.

Insbesondere handelt es sich nach der Erfindung um ein Verfahren zum Betreiben eines elektromechanischen Elements oder eines Aktors.

Bei den Ausführungsformen des erfindungsgemäßen Verfahrens kann vorgesehen sein, dass der Signal-Zwischenabschnitt eine zeitabhängige Steigung aufweist, die betragsmäßig maximal 10 Grad beträgt.

Bei den Ausführungsformen des erfindungsgemäßen Verfahrens kann vorgesehen sein, dass der Signalabschnitt des zweiten Spannungssignals beginnt, nachdem wenigstens 10 % und maximal 90 % des Zeitintervalls t_{z} des Signal-Zwischenabschnitts verstrichen sind oder 50 % des Zeitintervalls vor Ende desselben.

Bei den Ausführungsformen des erfindungsgemäßen Verfahrens kann vorgesehen sein, dass sich der Signalabschnitt des zweiten Spannungssignals bis in einen benachbarten und zeitlich nachfolgenden Signal-Zwischenabschnitt erstreckt und innerhalb dessen Zeitintervall t_{z} oder bis zu seinem Ende endet.

Bei den Ausführungsformen des erfindungsgemäßen Verfahrens kann vorgesehen sein, dass der Signalabschnitt des zweiten Spannungssignals sinusförmig ist.

Bei den Ausführungsformen des erfindungsgemäßen Verfahrens kann vorgesehen sein, dass die maximale Amplitude des Signalabschnitts des zweiten Spannungssignals höchstens 50 % der maximalen Amplitude des ersten Spannungssignals beträgt.

Bei den Ausführungsformen des erfindungsgemäßen Verfahrens kann vorgesehen sein,
dass das Ansteuern des ersten Ansteuerabschnitts ein gleichzeitiges Ansteuern von mehreren ersten Ansteuer-Teilabschnitten, die den ersten Ansteuerabschnitt bilden und in der Längsrichtung hintereinander gelegen sind, mit dem ersten Spannungssignal ist,
dass das Ansteuern des zweiten Ansteuerabschnitts ein gleichzeitiges Ansteuern von mehreren zweiten Ansteuer-Teilabschnitten, die den zweiten Ansteuerabschnitt bilden und in der Längsrichtung hintereinander gelegen sind, mit dem zweiten Spannungssignal ist.

Bei den Ausführungsformen des erfindungsgemäßen Verfahrens kann vorgesehen sein, dass gleichzeitig mit der Ansteuerung des ersten Ansteuerabschnitts ein durch eine elektrische Spannung deformierbarer dritter Ansteuerabschnitt mit dem ersten Spannungssignal angesteuert wird, wobei der dritte Ansteuerabschnitt derart angeordnet ist, dass der zweite Ansteuerabschnitt zwischen dem ersten und dem dritten Ansteuerabschnitt gelegen ist.

Bei den Ausführungsformen des erfindungsgemäßen Verfahrens kann vorgesehen sein, dass das Ansteuern des dritten Ansteuerabschnitts ein gleichzeitiges Ansteuern von mehreren dritten Ansteuer-Teilabschnitten, die den dritten Ansteuerabschnitt bilden und in der Längsrichtung hintereinander gelegen sind, mit dem ersten Spannungssignal ist.

Nach der Erfindung ist ein Aktor vorgesehen, der aufweist:
einen sich in einer Längsrichtung erstreckenden und durch eine elektrische Spannung deformierbaren ersten Ansteuerabschnitt, der aufweist: einen ersten Deformationskörper, der durch eine erste Außenfläche und zwei zueinander entgegen gesetzt gelegene Endflächen, zwischen denen sich die erste Außenfläche entlang der Längsrichtung erstreckt, umgrenzt ist, und zwei sich quer zur Längsrichtung erstreckende Aktuierungs-Elektroden, von denen eine als Erreger-Elektrode wirkende Aktuierungs-Elektrode an der ersten Endfläche und eine als gemeinsame Elektrode wirkende Aktuierungs-Elektrode an der zweiten Endfläche angeordnet ist,
einen sich in der Längsrichtung erstreckenden und durch eine elektrische Spannung deformierbaren zweiten Ansteuerabschnitt, der aufweist: einen zweiten Deformationskörper, der in der Längsrichtung an dem ersten Deformationskörper angeordnet ist, der durch eine zweite Außenfläche und zwei zueinander entgegen gesetzt gelegene Endflächen, zwischen denen sich die zweite Außenfläche entlang der Längsrichtung erstreckt, umgrenzt ist, und zwei sich quer zur Längsrichtung erstreckende Aktuierungs-Elektroden, von denen eine als Erreger-Elektrode wirkende Aktuierungs-Elektrode an der ersten Endfläche und eine als gemeinsame Elektrode wirkende Aktuierungs-Elektrode an der zweiten Endfläche angeordnet ist,
eine erste Ansteuerungs-Elektrode, die an einem ersten Anschluss-Abschnitt der ersten Außenfläche angeordnet ist und elektrisch mit der Erreger-Elektrode des ersten Ansteuerabschnitts verbunden ist,
eine zweite Ansteuerungs-Elektrode, die elektrisch von der ersten Ansteuerungs-Elektrode getrennt ist, an einem zweiten Anschluss-Abschnitt der zweiten Außenfläche angeordnet ist und elektrisch mit der Erreger-Elektrode des zweiten Ansteuerabschnitts verbunden ist, und
eine Referenz-Elektrode, die an der ersten Außenfläche und der zweiten Außenfläche und getrennt von der ersten Ansteuerungs-Elektrode und getrennt von der zweiten Ansteuerungs-Elektrode gelegen und elektrisch mit den gemeinsamen Elektroden des ersten und des zweiten Deformationskörpers verbunden ist.

Der erfindungsgemäße Aktor ist insbesondere zur Anwendung einer Ausführungsform des erfindungsgemäßen Verfahrens geeignet. Auch kann vorgesehen sein, dass der Aktor zur Ausführung des erfindungsgemäßen Verfahrens ausgebildet ist.

Bei den Ausführungsformen des erfindungsgemäßen Aktors kann vorgesehen sein, dass der Aktor weiterhin aufweist:
einen sich in einer Längsrichtung erstreckenden und durch eine elektrische Spannung deformierbaren dritten Ansteuerabschnitt, der an einer Seite des zweiten Ansteuerabschnitts gelegen ist, die in Bezug auf die Längsrichtung entgegen gesetzt zu der Seite mit dem ersten Ansteuerabschnitt gelegen ist, und der aufweist: einen dritten Deformationskörper, der durch eine dritte Außenfläche und zwei zueinander entgegen gesetzt gelegene Endflächen, zwischen denen sich die dritte Außenfläche entlang der Längsrichtung erstreckt, umgrenzt ist, und zwei sich quer zur Längsrichtung erstreckende Aktuierungs-Elektroden, von denen eine als Erreger-Elektrode wirkende Aktuierungs-Elektrode an der ersten Endfläche und eine als gemeinsame Elektrode wirkende Aktuierungs-Elektrode an der zweiten Endfläche angeordnet ist, und
eine dritte Ansteuerungs-Elektrode, die an einem dritten Anschluss-Abschnitt der dritten Außenfläche angeordnet ist und elektrisch mit der Erreger-Elektrode des dritten Ansteuerabschnitts verbunden ist,
wobei die Referenz-Elektrode zusätzlich an der dritten Außenfläche des dritten Deformationskörpers und getrennt von der dritten Ansteuerungs-Elektrode gelegen und elektrisch mit der gemeinsamen Elektrode des dritten Deformationskörpers verbunden ist.

Bei den Ausführungsformen des erfindungsgemäßen Aktors kann die dritte Ansteuerungs-Elektrode einteilig mit der ersten Ansteuerungs-Elektrode gebildet sein.

Bei den Ausführungsformen des erfindungsgemäßen Aktors kann wenigstens einer der Ansteuerabschnitte aus einer Abfolge von mehreren Ansteuer-Teilabschnitten gebildet sein, wobei jeder der Ansteuer-Teilabschnitte aus einer sich quer zur Längsrichtung erstreckenden plattenförmigen Erreger-Elektrode, aus einer sich quer zur Längsrichtung erstreckenden plattenförmigen allgemeinen Elektrode und einer in der Längsrichtung zwischen diesen gelegenen Schicht aus einem elektromechanischen, insbesondere piezoelektrischen Material, wobei die Schicht jeweils zwischen der Erreger-Elektrode und der allgemeinen Elektrode gelegen ist, gebildet ist.

Bei den Ausführungsformen des erfindungsgemäßen Aktors kann wenigstens einer der Deformationskörper, aus einem homogenen und elektrisch deformierbaren Material gebildet sein.

Bei den Ausführungsformen des erfindungsgemäßen Aktors ist ein Friktionselement an einem in der Längsrichtung orientierten Endabschnitt des ersten Ansteuerabschnitts oder des zweiten Ansteuerabschnitts angeordnet.

Nach der Erfindung ist eine Antriebsvorrichtung mit einer erfindungsgemäßen Ausführungsform des Aktors und mit einer wenigstens abschnittsweise elastisch ausgebildeten Halterungsvorrichtung vorgesehen, wobei der Aktor in der Halterungsvorrichtung gehalten und bevorzugt darin eingespannt ist.

Bei den Ausführungsformen der erfindungsgemäßen Antriebsvorrichtung kann die Halterungsvorrichtung als den Aktor wenigstens abschnittsweise umfangenden Spannrahmen ausgebildet sein.

Nach der Erfindung ist ein Motor mit einer erfindungsgemäßen Ausführungsform der Antriebsvorrichtung und einem anzutreibenden Element vorgesehen, das gegenüber der Antriebsvorrichtung bewegbar gelagert ist und das sich mit einem an dem Aktor angeordneten Friktionselement in einem Friktionskontaktkontakt befindet.

Im Folgenden wird die Erfindung an Hand der beiliegenden Figuren beschrieben, die zeigen:
Figur 1 eine perspektivische Darstellung eines Aktors, der nicht einTeil der Erfindung ist, der eine Gruppe von zwei Ansteuerabschnitten jeweils mit einem Deformationskörper, der zwei Ansteuerungs-Elektroden und eine Referenz-Elektrode aufweist, wobei in der Figur 1 die zwei Ansteuerungs-Elektroden gezeigt sind,
Figur 2 eine weitere perspektivische Darstellung des Aktors der Figur 1 aus einer Blickrichtung, die zu der Blickrichtung der Figur 1 entgegen gesetzt ist, wobei in der Figur 2 die Referenz-Elektrode gezeigt ist,
Figur 3 ein FEM-Modell betreffend die beiden Deformationskörper der Figur 1 als einheitlichen Deformationsblock dargestellt in einem Ruhezustand,
Figur 4 die FEM-Simulation eines bezogen auf seine Längsrichtung kontrahierten Zustands des Deformationsblocks gemäß Figur 3,
Figur 5 die FEM-Simulation eines bezogen auf seine Längsrichtung expandierten Zustands des Deformationsblocks gemäß Figur 3,
Figur 6 eine perspektivische Darstellung eines Aktors
   der nicht ein Teil der Erfindung ist,
   der eine Gruppe von drei Ansteuerabschnitten jeweils mit einem Deformationskörper, der zwei Ansteuerungs-Elektroden und eine Referenz-Elektrode aufweist, umfasst, wobei in der Figur 6 die zwei Ansteuerungs-Elektroden gezeigt sind,
Figur 7 eine weitere perspektivische Darstellung des Aktors der Figur 6 aus einer Blickrichtung, die zu der Blickrichtung der Figur 1 entgegen gesetzt ist, wobei in der Figur 7 die Referenz-Elektrode gezeigt ist,
Figur 8 eine perspektivische Darstellung des Aktors, die eine Variante des Aktors der Figur 6 ist, die eine Gruppe von drei Ansteuerungs-Elektroden und eine Referenz-Elektrode aufweist,
Figur 9 eine schematische Funktionsdarstellung einer Ansteuerungsvorrichtung des Aktors mit drei Ansteuerabschnitten, wobei der Aktor in Explosionsdarstellung gezeigt ist, wobei die Funktionsdarstellung die Ansteuerung durch zwei Spannungssignale zeigt,
Figur 10 eine schematische Funktionsdarstellung des Aktors gemäß der Figur 6 oder der Figur 8 sowie diesen Aktor, wobei der Aktor in Explosionsdarstellung gezeigt ist, wobei die Funktionsdarstellung die Ansteuerung durch zwei Spannungssignale zeigt,
Figur 11 zwei Spannungs-Zeit-Diagramme zur Darstellung eines ersten und eines zweiten Spannungssignals, mit denen der Aktor gemäß der Figur 6 oder der Figur 8 in einem erfindungsgemäßen Verfahren betrieben wird,
Figur 12 ein Spannungs-Zeit-Diagramm, in dem ein Summen-Spannungssignal dargestellt ist, das aus der Überlagerung des ersten und des zweiten Spannungssignals der Figur 11 resultiert,
Figur 13 ein Spannungs-Zeit-Diagramm, in dem das erste Spannungssignal der Figur 11 zusammen mit Zeitabschnitten eingetragen ist,
Figur 14 ein Spannungs-Zeit-Diagramm, in dem das Summen-Spannungssignal der Figur 12 zusammen mit Zeitabschnitten eingetragen ist,
Figur 15 zwei Spannungs-Zeit-Diagramme zur Darstellung eines ersten und eines zweiten Spannungssignals, die sich von den Spannungssignalen der Figur 11 unterscheiden,
Figur 16 ein Spannungs-Zeit-Diagramm, in dem ein Summen-Spannungssignal dargestellt ist, das aus der Überlagerung des ersten und des zweiten Spannungssignals der Figur 15 resultiert,
Figur 17 eine perspektivische Darstellung einer Ausführungsform eines erfindungsmäßen Motors mit einem Aktor nach der Erfindung, einer Haltevorrichtung, einem Friktionselement und einem angetriebenen Element,
Figur 18 eine Draufsicht des Motors nach der Figur 17,
Figur 19 eine Schnittdarstellung des Motors nach der Figur 17,
Figur 20 eine perspektivische Darstellung einer Ausführungsform eines erfindungsmäßen Motors,
Figur 21 eine Seitenansicht des Motors nach der Figur 20,
Figur 22 eine perspektivische Darstellung einer Ausführungsform des Motors der Figur 20 in einer Ansicht von unten aus der Richtung der Haltevorrichtung,
Figur 23 eine perspektivische Darstellung der Ausführungsform der in den Figuren 20 bis 22 dargestellten Antriebsvorrichtung, wobei zusätzlich das anzutreibende Element dargestellt ist,
Figur 24 eine Seitendarstellung der in den Figuren 20 bis 23 dargestellten Ausführungsform der Antriebsvorrichtung,
Figur 25 eine Draufsicht der in den Figuren 20 bis 23 dargestellten Ausführungsform der Antriebsvorrichtung,
Figur 26 eine perspektivische Darstellung der in den Figuren 20 bis 23 dargestellten Ausführungsform der Antriebsvorrichtung,
Figur 27 eine Seitenansicht einer weiteren Ausführungsform der Antriebsvorrichtung nach der Erfindung mit einem Aktor und einer Halterungsvorrichtung, in der der Aktor integriert ist, wobei sich die Antriebsvorrichtung in einem neutralen Deformationszustand befindet,
Figur 28 eine weitere Seitenansicht der Antriebsvorrichtung der Figur 27, wobei sich die Antriebsvorrichtung in einem neutralen Deformationszustand befindet,
Figur 29 eine Draufsicht der Antriebsvorrichtung der Figuren 27 und 28,
Figur 30 eine perspektivische Darstellung einer Antriebsvorrichtung mit einem Aktor nach der Figur 8 und einer Halterungsvorrichtung nach der Figur 27, wobei sich die Antriebsvorrichtung in einem neutralen Deformationszustand befindet,
Figur 31 eine perspektivische Darstellung einer weiteren Ausführungsform der Antriebsvorrichtung nach der Erfindung, wobei die Antriebsvorrichtung einen Aktor nach der Figur 8 aufweist,
Figur 32 eine Seitenansicht der Antriebsvorrichtung der Figur 31, wobei sich die Antriebsvorrichtung in einem neutralen Deformationszustand befindet,
Figur 33 eine weitere Seitenansicht der Antriebsvorrichtung der Figur 31,
Figur 34 eine Draufsicht der Antriebsvorrichtung der Figur 31,
Figur 35 eine FEM-Simulation eines ersten Deformationszustands der Antriebsvorrichtung gemäß den Figuren 31 bis 34, ,
Figur 36 eine FEM-Simulation eines zweiten Deformationszustands der Antriebsvorrichtung gemäß den Figuren 31 bis 34, wobei der zweite Deformationszustand gegensätzlich bzw. entgegen gesetzt zu dem ersten Deformationszustand gemäß Figur 35 ist,
Figur 37 eine perspektivische Darstellung einer weiteren Ausführungsform der Antriebsvorrichtung, wobei die Antriebsvorrichtung zwei nebeneinander liegende Aktoren jeweils nach der Figur 8 aufweist und wobei sich die Aktoren in einem neutralen Deformationszustand befinden,
Figur 38 eine Seitenansicht der Antriebsvorrichtung der Figur 37,
Figur 39 eine Draufsicht der Antriebsvorrichtung der Figur 37,
Figur 40 eine perspektivische Darstellung einer Ausführungsform des erfindungsgemäßen Motors mit der Ausführungsform der Antriebsvorrichtung der Figur 37,
Figur 41 eine Seitenansicht der Ausführungsform des Motors der Figur 40,
Figur 42 eine FEM-Simulation eines ersten Deformationszustands der Antriebsvorrichtung gemäß Figur 39 bezüglich einer ersten Betriebsart,
Figur 43 eine FEM-Simulation eines zweiten Deformationszustands der Antriebsvorrichtung gemäß Figur 39 bezüglich einer ersten Betriebsart, wobei der zweite Deformationszustand gegensätzlich bzw. entgegen gesetzt zu dem Deformationszustand der Figur 31 ist,
Figur 44 eine FEM-Simulation eines ersten Deformationszustands der Antriebsvorrichtung gemäß Figur 39 bezüglich einer zweiten Betriebsart,
Figur 45 eine FEM-Simulation eines zweiten Deformationszustands der Antriebsvorrichtung gemäß Figur 39 bezüglich einer zweiten Betriebsart, wobei der zweite Deformationszustand gegensätzlich bzw. entgegen gesetzt zu dem Deformationszustand der Figur 44 ist.

Der erfindungsgemäße Aktor 1 ist aus einer Gruppe von zumindest zwei Ansteuerabschnitten A1 und A2 gebildet, die sich jeweils in einer Längsrichtung L des Aktors 1 erstrecken und in der Längsrichtung L gesehen hintereinander angeordnet sind. Der Aktor 1 ist als elektromechanisches und vorzugsweise als piezoelektrisches Element ausgebildet. Der Aktor 1 wird durch eine Aktor-Außenfläche FA und zwei in Bezug auf die Längsrichtung L zueinander entgegen gesetzt gelegene Aktor-Endflächen FE1, FE2, zwischen denen sich die Aktor-Außenfläche FA entlang der Längsrichtung L erstreckt, umgrenzt.

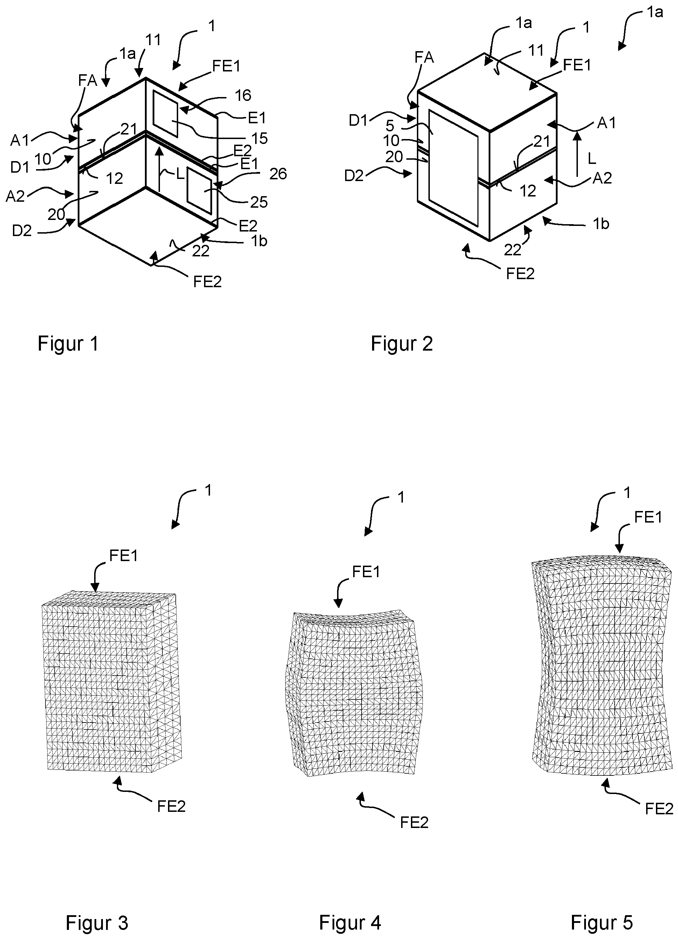

Die Figuren 1 und 2 zeigen einen Aktor 1, der nicht ein Teil der Erfindung bildet, der eine Gruppe von nur zwei Ansteuerabschnitten A1, A2 aufweist, die sich jeweils in einer Längsrichtung L des Aktors 1 erstrecken und in der Längsrichtung L gesehen hintereinander angeordnet sind.

Der erste Ansteuerabschnitt A1 weist einen ersten Deformationskörper D1, der durch eine erste Außenfläche 10 und zwei in Bezug auf die Längsrichtung L zueinander entgegen gesetzt gelegene Endflächen 11, 12, zwischen denen sich die erste Außenfläche 10 entlang der Längsrichtung L erstreckt, umgrenzt ist, und zumindest zwei sich quer zur Längsrichtung L erstreckende Aktuierungs-Elektroden E1, E2 auf. Die in der Längsrichtung L ausgebildeten Endflächen 11, 12 weisen eine erste Endfläche 11 als eine Aktor-Endfläche FE1 und eine zweite Endfläche 12 auf. Von den Aktuierungs-Elektroden E1, E2 ist in funktionaler Hinsicht aufgrund erfindungsgemäß vorgesehener Ansteuerung zumindest eine erste als eine Erreger-Elektrode E1 mit der Funktion einer Erreger-Elektrode an der ersten Endfläche 11 und zumindest eine gemeinsame Elektrode E2 an einer zweiten Endfläche 12 angeordnet. Innerhalb des ersten Deformationskörpers D1 können weitere sich quer zur Längsrichtung L erstreckende und voneinander beabstandete Aktuierungs-Elektroden E1, E2, zwischen denen jeweils elektromechanisches Material gelegen ist, zur Realisierung einer Multilayerstruktur angeordnet sein. Dabei können ausgehend von der ersten Endfläche 11 in der Längsrichtung L gesehen bis zur zweiten Endfläche 12 zumindest abschnittsweise abwechselnd aufgrund erfindungsgemäß vorgesehener Ansteuerung eine Erreger-Elektrode E1 und eine gemeinsame Elektrode E2 angeordnet sein. Bei den hierin beschriebenen Beispielen mit einer ersten Endfläche 11 kann diese eine erste Aktor-Endfläche FE1 bilden.

Der zweite Ansteuerabschnitt A2 weist einen zweiten Deformationskörper D2, der durch eine zweite Außenfläche 20 und zwei die in Bezug auf die Längsrichtung L zueinander entgegen gesetzt gelegene Endflächen 21, 22, zwischen denen sich die zweite Außenfläche 20 entlang der Längsrichtung L erstreckt, umgrenzt ist, und zumindest zwei sich quer zur Längsrichtung L erstreckende Aktuierungs-Elektroden E1, E2 auf. Die Endflächen 21, 22 weisen eine erste Endfläche 21 und eine zweite Endfläche 22 als eine Aktor-Endfläche FE2 auf. Wie bei dem ersten Ansteuerabschnitt A1 ist von den Aktuierungs-Elektroden E1, E2 in funktionaler Hinsicht aufgrund erfindungsgemäß vorgesehener Ansteuerung zumindest eine erste Elektrode E1 mit der Funktion einer Erreger-Elektrode an der ersten Endfläche 21 und zumindest eine gemeinsame Elektrode E2 an der zweiten Endfläche 22 angeordnet. Innerhalb des zweiten Deformationskörpers D2 können weitere sich quer zur Längsrichtung erstreckende und voneinander beabstandete Aktuierungs-Elektroden E1, E2 und jeweils dazwischen liegenden Schichten elektromechanischen Materials zur Realisierung einer Multilayerstruktur angeordnet sein. Dabei können ausgehend von der ersten Endfläche 21 in der Längsrichtung L gesehen bis zur zweiten Endfläche 22 zumindest abschnittsweise abwechselnd aufgrund erfindungsgemäß vorgesehener Ansteuerung eine Erreger-Elektrode E1 und eine gemeinsame Elektrode E2 angeordnet sein. Der Aktor 1 mit den zwei Ansteuerabschnitten A1, A2 erstreckt sich in der Längsrichtung L zwischen den Endflächen 11, 22, die die Aktor-Endflächen FE1 bzw. FE2 bilden.

Der Aktor 1 der Figuren 1 und 2 weist weiterhin eine erste Ansteuerungs-Elektrode 15 und eine zweite Ansteuerungs-Elektrode 25 auf, die beide in Bezug auf die Ansteuerabschnitte A1 bzw. A2 äußere Elektroden sind. Die erste Ansteuerungs-Elektrode 15 ist an der ersten Außenfläche 10 und die zweite Ansteuerungs-Elektrode 25 ist an der zweiten Außenfläche 20 angeordnet. Die Ansteuerungs-Elektroden 15, 25 sind elektrisch voneinander getrennt an der äußeren Fläche des Aktors 1 gelegen. Die erste Ansteuerungs-Elektrode 15 ist an einem ersten Anschluss-Abschnitt 16 der ersten Außenfläche 10 angeordnet und elektrisch mit der zumindest einen Erreger-Elektrode E1 des ersten Ansteuerabschnitts A1 verbunden. Die zweite Ansteuerungs-Elektrode 25 ist an einem zweiten Anschluss-Abschnitt 26 der zweiten Außenfläche 20 angeordnet ist und elektrisch mit der zumindest einen Erreger-Elektrode E1 des zweiten Ansteuerabschnitts A2 verbunden. Die Anschluss-Abschnitte 16 und 26 sind voneinander beanstandet gelegen.

Der Aktor 1 weist weiterhin eine Referenz-Elektrode 5 auf, die an der ersten Außenfläche 10 des ersten Deformationskörpers D1 und der zweiten Außenfläche 20 des zweiten Deformationskörpers D2 angeordnet ist und die sich zumindest teilweise über beide Außenflächen 10, 20 oder im Wesentlichen über beide Außenflächen 10, 20 erstreckt. Somit ist die Referenz-Elektrode 5 in Bezug auf die Ansteuerabschnitte A1, A2 eine äußere Elektrode. Die Referenz-Elektrode 5 ist elektrisch getrennt von der ersten Ansteuerungs-Elektrode 15 und der zweiten Ansteuerungs-Elektrode 25 angeordnet und elektrisch mit der zumindest einen gemeinsamen Elektrode E2 des ersten und des zweiten Deformationskörpers D1 und D2 verbunden.

Ausführungsformen der Erfindung weisen ein Friktionselement F auf, das an einer in der Längsrichtung L orientierten Aktuierungsfläche 1a gelegen ist, welche die Deformationsbewegungen der ersten Endfläche 11 des Aktors 1 übernimmt und auf das Friktionselement F überträgt.

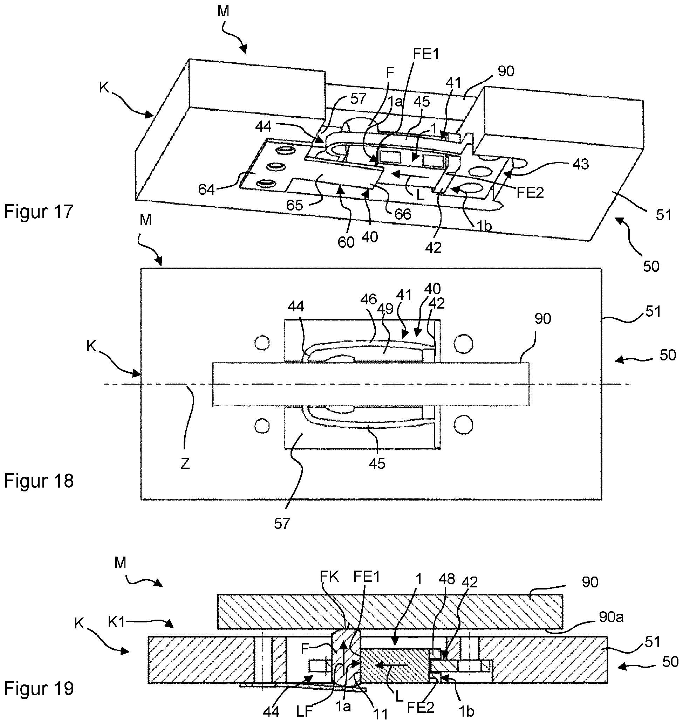

Für die den Figuren 17 bis 26 entnehmbaren Ausführungsformen des Aktors 1 ist das Friktionselement F an der ersten Endfläche 11 des ersten Ansteuerabschnitts A1 gelegen, so dass diese die Aktuierungsfläche 1a ist. Das Friktionselement F kann direkt oder indirekt an der ersten Endfläche 11 anliegen. In diesem Zusammenhang bedeutet "indirekt", dass zwischen der ersten Endfläche 11 und dem Friktionselement F eine Zwischenschicht oder eine Strukturkomponente mit einer Außenfläche als Aktuierungsfläche 1a gelegen sein kann, die entlang der Orientierungsrichtung der ersten Endfläche 11 oder entlang der Längsrichtung L orientiert ist und die eine Deformation ersten Endfläche 11 des Aktors 1 aufnimmt und eine Positions- und Lage-Änderung des Friktionselements F bewirkt.

Bei der Ausführungsform der Figuren 17 bis 26 ist in der Längsrichtung L gesehen entgegen gesetzt zu der Aktuierungsfläche 1a an der zweiten Aktor-Endfläche FE2 eine Lagerplatte 42 angeordnet, deren entlang der Aktor-Endfläche FE2 orientierte Außenfläche als eine Lagerungsfläche 1b ausgebildet. Bei anderen Ausführungsformen der Erfindung kann die Lagerungsfläche 1b die zweite Aktor-Endfläche FE2 oder z.B. die Endfläche 22 bzw. 32 selbst oder eine Außenfläche einer auf oder an der zweiten Endfläche 22 bzw. 32 gelegenen Schicht oder eines an der zweiten Endfläche 22 bzw. 32 gelegenen Strukturbauteils sein, wobei die Lagerungsfläche 1b entlang der Orientierungsrichtung der ersten Endfläche 11 oder entlang der Längsrichtung L orientiert ist.

Bei den Ausführungsformen gemäß den Figuren 17 bis 26 erstreckt sich das Friktionselement F in einer Längsrichtung LF. Das Friktionselement F kann aus einem harten und abriebfesten Material gebildet sein oder bestehen. Das Material kann insbesondere aus einem keramischen Material, einem Metall oder einem Kunststoff oder einer Kombination dieser Materialien gebildet sein oder bestehen. Das Material ist derart vorgesehen, dass mit diesem ein Friktionskontakt mit dem jeweiligen anzutreibenden Element realisierbar ist.

Figur 3 zeigt das FEM-Modell für die Kombination von Ansteuerabschnitten A1, A2 gemäß den Figuren 1 und 2 als aktuierbarem und einheitlichem Deformationsblock, während die Figuren 4 und 5 verschiedene Deformationszustände eines solchen Deformationsblocks verdeutlichen. Diese Deformationszustände des Deformationsblocks können bei entsprechender Ansteuerung der Ansteuerungs-Elektroden 15 und 25 mittels elektrischer Spannungssignale bezogen auf eine an der Referenz-Elektrode 5 anliegenden Referenzspannung in dynamischer Abfolge erzeugt werden, um das Friktionselement F zu betätigen bzw. entlang einer definierten Bewegungsbahn oder Trajektorie zu bewegen. Das Friktionselement F ist dazu vorgesehen, mit einer Friktionsoberfläche eines anzutreibenden Elements 90 zusammenzuwirken, und kann bei Erzeugung einer dynamischen Abfolge der verschiedenen Deformationszustände gemäß den Figuren 4 und 5 das anzutreibende Element 90 relativ zum Aktor 1 bewegen.

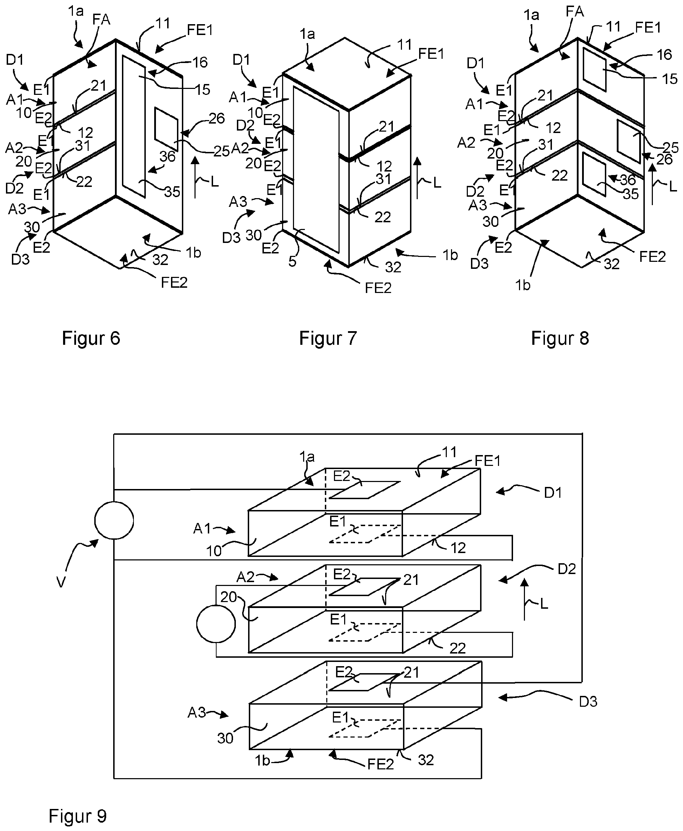

Die Figuren 6 und 7 zeigen weitere Beispiele des Aktors 1, die nicht Teil der Erfindung sind, der eine Gruppe von drei Ansteuerabschnitten A1, A2, A3 aufweist, die sich jeweils in einer Längsrichtung L des Aktors 1 erstrecken und in der Längsrichtung L gesehen hintereinander angeordnet sind.

Bei diesem Beispiel weist der Aktor 1 zusätzlich einen sich in einer Längsrichtung erstreckenden und durch eine elektrische Spannung deformierbaren dritten Ansteuerabschnitt A3 auf, wobei der zweite Ansteuerabschnitt A2 zwischen dem ersten Ansteuerabschnitt A1 und dem dritten Ansteuerabschnitt A3 gelegen ist, so dass die Ansteuerabschnitte A1, A2 und A3 in der Längsrichtung L gesehen hintereinander gelegen sind. Der dritte Ansteuerabschnitt A3 weist auf: einen dritten Deformationskörper D3, der durch eine dritte Außenfläche 30, und eine erste Endfläche 31 und eine zweite Endfläche 32 als zweiter Aktor-Endfläche FE2, die in Bezug auf die Längsrichtung L entgegen gesetzt zu der ersten Endfläche 31 gelegen ist, umgrenzt ist, und zumindest zwei sich quer zur Längsrichtung erstreckende Aktuierungs-Elektroden E1, E2. Die dritte Außenfläche 30 erstreckt sich zwischen den Endflächen 31, 32 entlang der Längsrichtung L. Die Aktuierungs-Elektroden E1, E2 sind aufgrund erfindungsgemäß vorgesehener Ansteuerung durch zumindest eine Erreger-Elektrode E1, die an der ersten Endfläche 31 angeordnet ist, und zumindest eine gemeinsame Elektrode E2, die an der zweiten Endfläche 32 angeordnet ist, realisiert. Innerhalb des dritten Deformationskörpers D3 können weitere sich quer zur Längsrichtung erstreckende und voneinander beabstandete Aktuierungs-Elektroden E1, E2 mit jeweils dazwischen liegenden Schichten elektromechanischen Materials angeordnet sein und auf diese Weise eine MultilayerStruktur bilden. Dabei können ausgehend von der ersten Endfläche 31 in der Längsrichtung L gesehen bis zur zweiten Endfläche 32 zumindest abschnittsweise abwechselnd aufgrund erfindungsgemäß vorgesehener Ansteuerung eine Erreger-Elektrode E1 und eine gemeinsame Elektrode E2 angeordnet sein.

Der Aktor 1 nach den Figuren 6 und 7 weist eine dritte Ansteuerungs-Elektrode 35 auf, die an einem dritten Anschluss-Abschnitt 36 der dritten Außenfläche 30 angeordnet ist und elektrisch mit der zumindest einen Erreger-Elektrode E1 des dritten Ansteuerabschnitts A3 verbunden ist. Somit können die Anschluss-Abschnitte 16, 26 und 36 zueinander beanstandet gelegen sein.

Die dritte Ansteuerungs-Elektrode 35 kann mit der ersten Ansteuerungs-Elektrode 15 elektrisch verbunden sein. Diese elektrische Verbindung kann hierzu mit externen Leitungen realisiert sein. Dazu alternativ oder zusätzlich können, wie in der Ausführungsform des Aktors 1 nach den Figuren 6 und 7 vorgesehen, die erste Ansteuerungs-Elektrode 15 und die dritte Ansteuerungs-Elektrode 35 zusammen einstückig ausgebildet oder zusammen als ein Stück hergestellt sein. Die Referenz-Elektrode 5 ist elektrisch getrennt von der ersten, zweiten und dritten Ansteuerungs-Elektrode 15, 25, 35 angeordnet und elektrisch mit der zumindest einen gemeinsamen Elektrode E2 des ersten Deformationskörpers D1 und des zweiten Deformationskörpers D2 und des dritten Deformationskörpers D3 verbunden. Bei der Ausführungsform des Aktors 1 nach der Figur 8 sind die erste Ansteuerungs-Elektrode 15 und die dritte Ansteuerungs-Elektrode 35 als eigene Stücke, also jeweils einstückig ausgebildet und dementsprechend voneinander beabstandet gelegen. Ansonsten ist das Beispiel des Aktors 1 nach der Figur 8 wie die Ausführungsform des Aktors 1 nach den Figuren 6 und 7 ausgebildet.

Insbesondere kann die erste Ansteuerungs-Elektrode 15, die zweite Ansteuerungs-Elektrode 25, die dritte Ansteuerungs-Elektrode 35 und die Referenz-Elektrode 5, oder eine oder mehrere dieser Elektroden, als auf die jeweilige Außenfläche oder jeweiligen Außenflächen aufgebrachte Schicht oder als flexible Platte oder als unflexible Platte ausgeführt sein.

Der Aktor 1 mit den drei Ansteuerabschnitten A1, A2, A3 erstreckt sich in der Längsrichtung L zwischen den Endflächen 11, 32, die die Aktor-Endflächen FE1 bzw. FE2 bilden.

Nach einem Beispiel des Aktors 1 ist der erste Deformationskörper D1, der zweite Deformationskörper D2 und der dritte Deformationskörper D3 oder einer oder mehrere dieser Deformationskörper jeweils aus einem homogenen und elektrisch verformbaren Material, d.h. als Bulk und ohne eine Multilayerstruktur aufweisend gebildet. Ein Ansteuerabschnitt mit einem solchen als Bulk gebildeten Deformationskörper weist zumindest zwei Aktuierungs-Elektroden E1, E2 auf, die insbesondere an jeweils einem von zwei in der Längsrichtung L entgegen gesetzt zueinander gelegenen Endflächen des jeweiligen Deformationskörpers ausgebildet sind. Eine oder auch beide der Elektroden können auch innerhalb des Bulk und voneinander in der Längsrichtung L beabstandet angeordnet sein.

Ein Beispiel bei dem drei Deformationskörper D1, D2 und D3 des Aktors 1 jeweils als Bulk ausgeführt sind, ist in der Figur 9 gezeigt. Dabei weist jeder der Ansteuerabschnitte A1, A2, A3 zwei Aktuierungs-Elektroden E1, E2 auf, von denen eine erste jeweils an der ersten Endfläche und eine zweite jeweils an der zweiten Endfläche des jeweiligen Deformationskörpers D1, D2, D3 angeordnet ist, um den jeweiligen Deformationskörper in vorbestimmter Weise zu deformieren, wenn mittels einer Signalerzeugungs-Vorrichtung V ein entsprechendes Spannungssignal an den zugehörigen Aktuierungs-Elektroden E1, E2 angelegt wird.

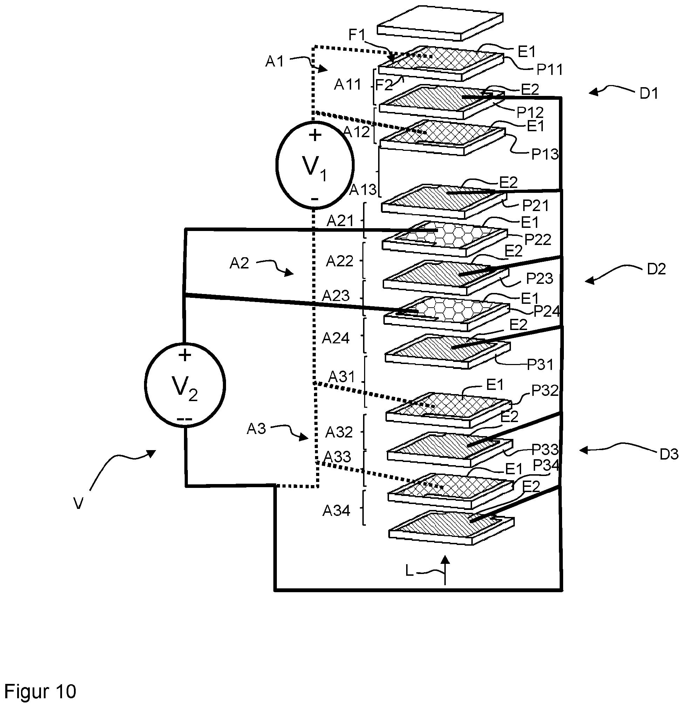

Dazu alternativ oder zusätzlich kann bei dem erfindungsgemäßen Aktor 1 einer oder können mehrere seiner Ansteuerabschnitte aus mehreren Ansteuer-Teilabschnitten gebildet sein, die sich jeweils quer zur Längsrichtung L erstrecken und in der Längsrichtung L schichtförmig übereinander gelegen sind. Jeder Ansteuer-Teilabschnitt ist jeweils aus einer sich quer zur Längsrichtung erstreckenden plattenförmigen Aktuierungs-Elektrode mit der Funktion einer Erreger-Elektrode, aus einer sich quer zur Längsrichtung erstreckenden plattenförmigen Aktuierungs-Elektrode mit der Funktion einer allgemeinen Elektrode und aus einer in der Längsrichtung zwischen diesen Aktuierungs-Elektroden gelegenen piezoelektrischen Schicht, die elektromechanisch verformbar ist, gebildet. In der Figur 10 ist beispielartig eine Ausführungsform dargestellt, die drei Ansteuerabschnitte A1, A2, A3 aufweist, wobei jeder der Ansteuerabschnitte aus mehreren Ansteuer-Teilabschnitten gebildet ist:
der erste Ansteuerabschnitt A1 weist die Ansteuer-Teilabschnitte A11, A12, A13 mit den piezoelektrischen Schichten P11, P12, P13 auf,
der zweite Ansteuerabschnitt A2 weist die Ansteuer-Teilabschnitte A21, A22, A23, A24 mit den piezoelektrischen Schichten P21, P22, P23, P24 auf, und
der dritte Ansteuerabschnitt A3 weist die Ansteuer-Teilabschnitte A31, A32, A33, A34 mit den piezoelektrischen Schichten P31, P32, P33, P34 auf.

Jede piezoelektrische Schicht eines Ansteuer-Teilabschnitts A1, A2, A3 weist zueinander entgegen gesetzt gelegene Teilabschnitt-Endflächen F1, F2 auf, die sich quer zur Längsrichtung L erstrecken und in Bezug auf die Längsrichtung L zueinander entgegen gesetzt orientiert sind. An jeder Teilabschnitt-Endfläche F1, F2 ist eine Aktuierungs-Elektroden E1, E2 gelegen. Diese kann plattenförmig oder schichtförmig sein, oder eine andere Form haben, und z.B. als Leitungsabschnitt gebildet sein. Zwischen zwei Ansteuer-Teilabschnitten eines Ansteuer-Teilabschnitts A1, A2, A3 kann auch eine Materialschicht gelegen sein, die nicht elektromechanisch verformbar ist.

Beispielartig mit den Bezugszeichen der Figur 10 kann an dem Aktor 1 generell eine oder mehrere der folgenden Alternativen (a), (b), (c) realisiert sein, wenn an die Ansteuerabschnitte eine Signalerzeugungs-Vorrichtung V elektrisch angeschlossen ist:
(a) der erste Ansteuerabschnitt A1 ist aus einer Abfolge von mehreren ersten Ansteuer-Teilabschnitten A11, A12, A13 jeweils mit einer sich quer zur Längsrichtung erstreckenden plattenförmigen Erreger-Elektrode, mit einer sich quer zur Längsrichtung erstreckenden plattenförmigen allgemeinen Elektrode und einer in der Längsrichtung zwischen diesen gelegenen piezoelektrischen Schicht, die zwischen jeweils zwei Innenelektroden gelegen sind, gebildet;
(b) der zweite Ansteuerabschnitt A2 aus einer Abfolge von mehreren zweiten Ansteuer-Teilabschnitten A21, A22, A23, A24 jeweils mit einer sich quer zur Längsrichtung erstreckenden plattenförmigen Erreger-Elektrode, mit einer sich quer zur Längsrichtung erstreckenden plattenförmigen allgemeinen Elektrode und einer in der Längsrichtung zwischen diesen gelegenen piezoelektrischen Schicht, die zwischen jeweils zwei Innenelektroden gelegen sind, gebildet;
(c) der dritte Ansteuerabschnitt A3 aus einer Abfolge von mehreren dritten Ansteuer-Teilabschnitten A31, A32, A33 jeweils mit einer sich quer zur Längsrichtung erstreckenden plattenförmigen Erreger-Elektrode, mit einer sich quer zur Längsrichtung erstreckenden plattenförmigen allgemeinen Elektrode und einer in der Längsrichtung zwischen diesen gelegenen piezoelektrischen Schicht, die zwischen jeweils zwei Innenelektroden gelegen sind, gebildet.

Dabei kann der Ansteuerabschnitt oder können die Ansteuerabschnitte, die nicht nach (a), (b) oder (c) gebildet sind, in Bulk-Bauweise gebildet sein.

Der erfindungsgemäße Aktor 1 kann auch durch Kombinationen von Alternativen (a), (b), (c) mit von anhand der Figur 10 beschriebenen Merkmalen oder Ausführungsformen realisiert sein.

Der Aktor 1 kann an seiner Außenseite abschnittsweise oder vollständig beschichtet sein.

In dem nach der Erfindung realisierten Aktor 1, z.B. mit zumindest zwei Ansteuerabschnitten A1 und A2, können durch eine entsprechende Ansteuerung mit Spannungssignalen, die von der Signalerzeugungs-Vorrichtung V erzeugt werden und jeweils zwischen den in der Längsrichtung L benachbarten Aktuierungs-Elektroden E1, E2 wirken, die anhand der Figuren 4 und 5 gezeigten Verformungszustände in einander abwechselnder Folge hervorgerufen werden.

Die Aktuierungs-Elektroden E1, E2 können bei den hierin genannten Ausführungsformen des Aktors 1 sowie auch in Ansteuerabschnitten desselben in verschiedener Weise ausgeführt sein. Beispielsweise können die Aktuierungs-Elektroden E1, E2 plattenförmig, schichtförmig, als Leitungsabschnitt oder als Materialflecken ausgebildet sein.

Nach der Erfindung kann der Aktor 1 in einer Halterungsvorrichtung 40 gehalten und vorzugsweise darin strukturell integriert sein, so dass der Aktor 1 zusammen mit der Halterungsvorrichtung 40 eine Antriebsvorrichtung K ausbildet. Die Halterungsvorrichtung 40 kann als Spannrahmen 41 ausgeführt sein, der zumindest abschnittsweise aus einem elastischen Material gebildet ist und in den die Ansteuerabschnitte des jeweiligen Aktors 1 federnd eingespannt sind. Die Einspannkraft bzw. Druckkraft, die die Halterungsvorrichtung 40 auf den Aktor 1 ausübt, wirkt dabei in der Längsrichtung L des Aktors 1, um den Aktor 1 in dieser Richtung vorzuspannen. Auf diese Weise steht der Aktor unter einer Druckspannung und wird dadurch schneller von einem expandierten Zustand in einen kontrahierten Zustand rückgeführt. Die Halterungsvorrichtung 40 ist vorzugsweise derart ausgeführt, dass sich diese zumindest auf einer Seite des Aktors 1 über eine von der ersten Aktor-Endfläche FE des Aktors 1 zur zweiten Aktor-Endfläche FE2 desselben verlaufende Strecke erstreckt und somit den Aktor 1 in Längsrichtung L zumindest abschnittsweise umgibt bzw. umfängt oder umklammert.

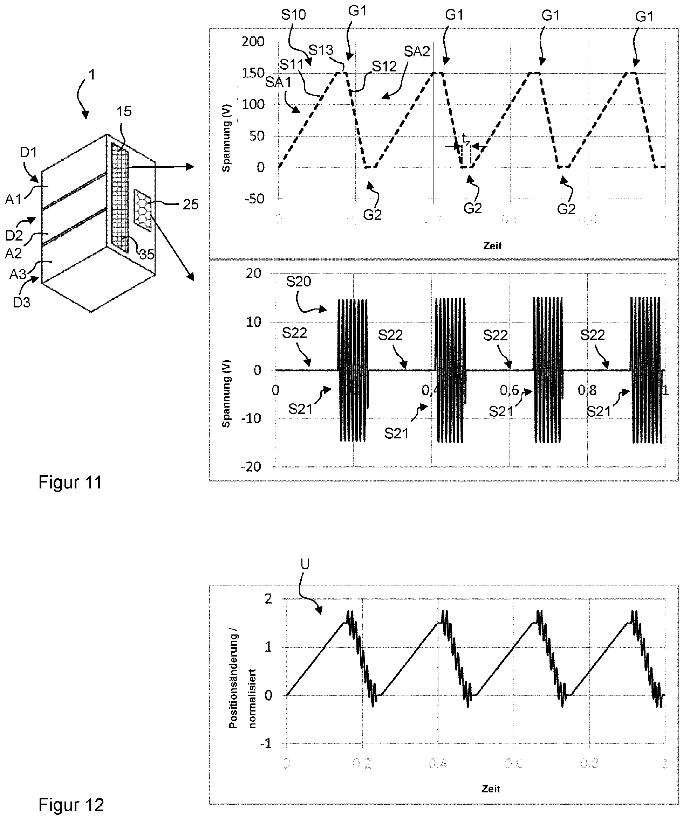

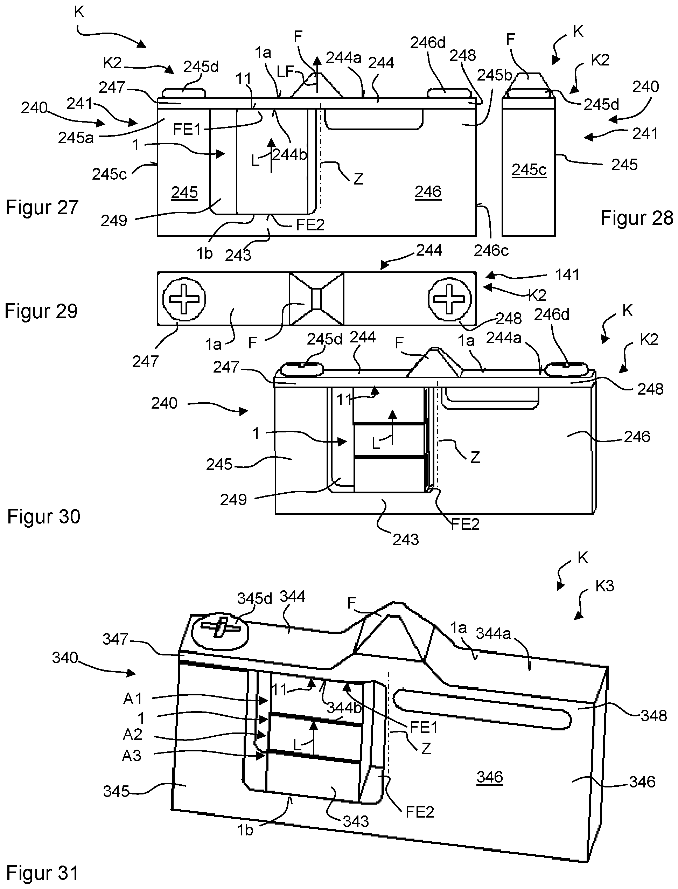

Nach der Erfindung ist ein Verfahren zum Betreiben eines Aktors 1 und vorzugsweise eines Aktors nach der vorstehenden Beschreibung mit zumindest zwei Ansteuerabschnitten A1, A2, die in einer Längsrichtung L des Aktors 1 hintereinander angeordnet sind, vorgesehen. Weiterhin ist nach der Erfindung ein Verfahren zum Betreiben einer Antriebsvorrichtung K, die einen erfindungsgemäßen Aktor 1 und ein an einer Aktuierungsfläche 1a angeordnetes Friktionselement F aufweist, vorgesehen. Das Friktionselement F kann dabei direkt oder indirekt, z.B. über eine dazwischen liegende Zwischenschicht oder Strukturkomponente, derart an der ersten Endfläche 11 des Aktors 1 angeordnet sein, so dass Deformationsbewegungen des Aktors 1 entsprechende Positions- und Lage-Änderungen des Friktionselements F bewirken. Die Deformationsbewegungen des Aktors 1 bewirken Positionsänderungen der Aktuierungsfläche 1a an der Stelle des Friktionselements F, die z.B. in den Figuren 12, 14 und 16 in Abhängigkeit der Zeit dargestellt sind. Bei den Ausführungsformen der Antriebsvorrichtung K der Figuren 17 bis 26 ist die äußere Aktuierungsfläche 1a an einer in der Längsrichtung L des Aktors 1 ausgebildeten Endfläche 11, 12 desselben gelegen. Diese Endfläche kann die Endfläche 11 des ersten Ansteuerabschnitts A1 des Aktors 1 sein, so dass in den Figuren 17 bis 26 diese Endfläche die mit dem Bezugszeichen "1a" bezeichnete Aktuierungsfläche ist. Bei den Figuren 27 bis 45 ist die Aktuierungsfläche eine Außenfläche einer an der Endfläche 11 angeordneten Strukturkomponente, die als Haltevorrichtung ausgeführt ist. Alternativ oder zusätzlich kann das Friktionselement F auch an einer zweiten Endfläche oder dritten Endfläche, die entgegen gesetzt zu der ersten Endfläche 11 orientiert ist, oder an einer Außenfläche einer jeweils daran angeordneten Schicht oder Strukturkomponente angeordnet sein.

Insbesondere ist der Aktor nach einer der hierin beschriebenen Ausführungsformen mit zumindest einem ersten durch eine elektrische Spannung deformierbaren Ansteuerabschnitt mit einer ersten Endfläche 11 und einem zweiten durch eine elektrische Spannung deformierbaren Ansteuerabschnitt mit einer weiteren Endfläche, die entgegen gesetzt zu der ersten Endfläche 11 orientiert ist, gebildet. Erfindungsgemäß kann ein Friktionselement F zur Ausbildung der Antriebsvorrichtung K an der ersten Endfläche 11 oder der weiteren Endfläche gelegen sein.

Dabei erfolgt ein Ansteuern eines ersten durch eine elektrische Spannung deformierbaren Ansteuerabschnitts A1 mit einem ersten Spannungssignal S10 und, in zeitlichen Abschnitten überlagert, ein Ansteuern eines zweiten durch eine elektrische Spannung deformierbaren Ansteuerabschnitts A2 mit einem zweiten Spannungssignal S20.

Das erste Spannungssignal S10 weist ein Signal auf, das gebildet ist aus: einer Mehrzahl von betragsmäßig ansteigenden Signalabschnitten oder Signalflanken S11, einer Mehrzahl von betragsmäßig abfallenden Signalabschnitten oder Signalflanken S12 und einer Mehrzahl von Signal-Zwischenabschnitten S13, von denen jeder jeweils zwischen einer betragsmäßig ansteigenden Signalflanke S11 und einer betragsmäßig abfallenden Signalflanke S12 gelegen ist. Die Signal-Zwischenabschnitte S13 erstrecken sich über ein von Null abweichendes Zeitintervall t_{z}, oderanders ausgedrückt: das Zeitintervall t_{z} erstreckt sich über eine Zeitdauer, die einen Wert ungleich Null hat.

Das erste Spannungssignal S10 weist betragsmäßig ansteigende Signalflanken und betragsmäßig abfallende Signalflanken auf. Der Ausdruck "betragsmäßig ansteigend" bedeutet in diesem Zusammenhang, dass das betreffende Signal in Richtung einer Zeitachse T zumindest abschnittsweise ansteigt, d.h. dass das Spannungssignal S10 erste Signalabschnitte SA1 mit einer Signalflanke S11 positiver Steigung aufweist. Der Ausdruck "betragsmäßig abfallend" bedeutet in diesem Zusammenhang, dass das betreffende Signal in Richtung einer Zeitachse T zumindest abschnittsweise abfällt, d.h. dass das Spannungssignal S10 zweite Signalabschnitte SA2 mit einer Signalflanke S12 negativer Steigung aufweist. Die ersten Signalabschnitte SA1 und die zweiten Signalabschnitte SA2 können generell zeitlich kontinuierliche, also zeitlich ununterbrochene Signalabschnitte, oder zeitlich diskontinuierliche, also zeitlich unterbrochene Signalabschnitte sein.

Die ersten Signalabschnitte SA1 müssen nicht notwendigerweise aus ansteigenden Signalflanken S11 bestehen, d.h. diese müssen nicht jeweils ausschließlich aus einer betragsmäßig ansteigenden Signalflanke S11 gebildet sein. Die ersten Signalabschnitte SA1 können auch Teilabschnitte ohne Steigung oder Teilabschnitte mit negativer Steigung aufweisen. Ebenso müssen die zweiten Signalabschnitte SA2 nicht notwendigerweise aus abfallenden Signalflanken S12 bestehen, d.h. diese müssen nicht jeweils ausschließlich aus einer betragsmäßig abfallenden Signalflanke S12 gebildet sein. Die zweiten Signalabschnitte SA2 können auch Teilabschnitte ohne Steigung oder Teilabschnitte mit negativer Steigung aufweisen.

Die ersten Signalabschnitte SA1 einer Ausführungsform des erfindungsgemäßen ersten Spannungssignals S1 können jedoch insbesondere so definiert sein, dass diese ausschließlich aus ansteigenden Signalflanken S11 gemäß der erfindungsgemäßen Definition gebildet sind oder bestehen. Alternativ oder zusätzlich können die zweiten Signalabschnitte SA2 einer Ausführungsform des erfindungsgemäßen ersten Spannungssignals S1 so definiert sein, dass diese ausschließlich aus abfallenden Signalflanken S12 gemäß der erfindungsgemäßen Definition gebildet sind oder bestehen.

Ein nach der Erfindung definierter Zwischenabschnitt S13 bildet ein lokales Maximum und unterscheidet sich sowohl von der betragsmäßig ansteigenden Signalflanke S11 als auch der betragsmäßig abfallenden Signalflanke S12 dadurch, dass sich die Signalform des erfindungsgemäßen Zwischenabschnitts S13 im zeitlichen Verlauf sowohl von der Signalform der betragsmäßig ansteigenden Signalflanke S11 als auch von der Signalform der betragsmäßig abfallenden Signalflanke S12 unterscheidet.

Zusätzlich kann der Signal-Zwischenabschnitt S13 dadurch definiert sein, dass dieser eine zeitabhängige Steigung aufweist, die einen Wert von maximal 10 Grad hat. Zusätzlich oder davon unabhängig kann definiert sein, dass die Steigung der betragsmäßig ansteigenden Signalflanke S11, die zeitlich unmittelbar vor dem Signal-Zwischenabschnitt S13 liegt, einen Wert von mehr als 10 Grad und vorzugsweise einen Wert von mehr als 20 Grad hat. Auch kann zusätzlich oder davon unabhängig definiert sein, dass die Steigung der betragsmäßig abfallenden Signalflanke S12, die zeitlich unmittelbar nach dem Signal-Zwischenabschnitt S13 liegt, einen Wert von mehr als 10 Grad und vorzugsweise einen Wert von mehr als 20 Grad hat. Bei diesen Varianten kann jeweils insbesondere definiert sein, dass die zeitliche Länge der betragsmäßig ansteigenden Signalflanke S11 größer ist als die zeitliche Länge des Signal-Zwischenabschnitts S13. Auch kann bei diesen Varianten jeweils insbesondere definiert sein, dass die zeitliche Länge der betragsmäßig abfallenden Signalflanke S12 größer ist als die zeitliche Länge des Signal-Zwischenabschnitts S13.

Eine Ausführungsform des im erfindungsgemäßen Verfahren verwendeten ersten Spannungssignals S10 weist eine Mehrzahl von betragsmäßig ansteigenden Signalflanken S11 auf, an die jeweils zeitlich direkt anschließend ein Zwischenabschnitt S13 folgt, wobei auf diesen Zwischenabschnitt S13 jeweils zeitlich direkt anschließend eine betragsmäßig abfallende Signalflanke S12 folgt. Ein Beispiel dieser Ausführungsform ist in der Figur 11 gezeigt. Erfindungsgemäß ist wesentlich, dass das erste Spannungssignal S10 mehrere Signalabschnitts-Gruppen G1 jeweils bestehend aus der Abfolge einer ansteigenden Signalflanke S11, eines zeitlich direkt anschließenden Zwischenabschnitts S13 und einer zeitlich direkt anschließenden abfallenden Signalflanke S12 aufweist. Nach einer erfindungsgemäßen Ausführungsform des ersten Spannungssignals S10 folgt beim Auftreten einer solchen Signalabschnitts-Gruppe G1 bestehend aus der Abfolge einer ansteigenden Signalflanke S11, eines zeitlich direkt anschließenden Zwischenabschnitts S13 und einer zeitlich direkt anschließenden abfallenden Signalflanke S12 und einer nach dieser Signalabschnitts-Gruppe zeitlich nächsten ansteigenden Signalflanke nicht notwendigerweise das Auftreten einer ebensolchen Gruppe. So können bei dem ersten Spannungssignal S10 nach einer ansteigenden Signalflanke S11 auch andere Signalabschnitte zeitlich folgen, die keinen nach der Erfindung definierten Zwischenabschnitt S13 aufweisen. Auch kann bei einem ersten Spannungssignal S10 auf eine betragsmäßig ansteigende Signalflanke S11 zeitlich direkt eine abfallende Signalflanke S12 folgen. Nach einer Ausführungsform des erfindungsgemäßen Verfahrens kann das erste Spannungssignal S10 jedoch auch mehrere Signalabschnitts-Gruppen G1 aufweisen, die zeitlich aufeinander folgen.

Eine Ausführungsform des im erfindungsgemäßen Verfahren verwendeten ersten Spannungssignals S10 kann aus einer zeitlichen Abfolge von Signalabschnitts-Gruppen G1 jeweils bestehend aus einer ansteigenden Signalflanke S11, eines zeitlich direkt anschließenden Zwischenabschnitts S13 und einer zeitlich direkt anschließenden abfallenden Signalflanke S12 gebildet sein, wobei jede Signalabschnitts-Gruppe G1 insbesondere eine Sägezahn-Form oder eine Trapez-Form oder im Wesentlichen eine dieser Formen haben kann, also die Signalflanke S11, der Zwischenabschnitt S13 und die Signalflanke S12 jeweils geradlinig gebildet sind.

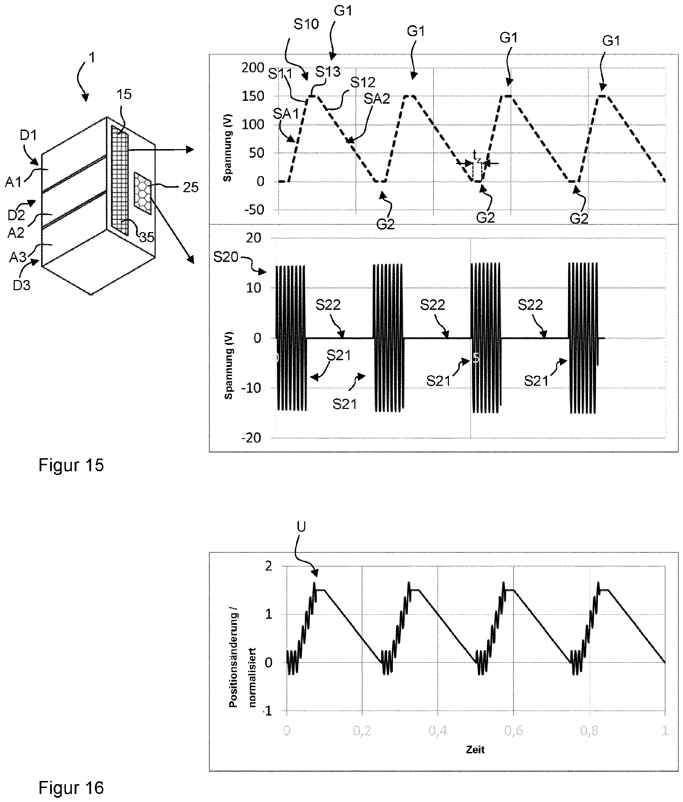

Bei den Ausführungsformen des erfindungsgemäßen Verfahrens weist das zweite Spannungssignal S20 zumindest einen relativ hochfrequenten Signalabschnitt S21 auf. Das zweite Spannungssignal S20 kann dabei zumindest einen Verbindungs-Signalabschnitt S22 aufweisen, der jeweils zwei relativ hochfrequente Signalabschnitte S21 verbindet. Der Verbindungs-Signalabschnitt S22 kann, wie in den Figuren 11 und 15 gezeigt, einen zeitlich konstanten Wert und insbesondere den Wert Null haben. Der Verbindungs-Signalabschnitt S22 kann alternativ dazu ein relativ niederfrequentes Signal bestehend oder aus diesem gebildet sein.

Ein Beispiel einer Ausführungsform des Verfahrens, bei dem eine Ansteuerung eines Aktors 1, der drei Ansteuerabschnitte A1, A2, A3 aufweist, mit einem ersten Spannungssignal S10 mit Trapez-Form und dem zweiten Spannungssignal S20 ist in der Figur 11 gezeigt. Der relativ hochfrequente Signalabschnitt S21 des zweiten Spannungssignals S20 beginnt in den Zwischenabschnitten S13 und erstreckt sich über die sich an diese jeweils anschließende abfallende Signalflanke S12 und auch noch über einen Teil des sich an diese jeweils anschließenden Zwischenabschnitts S13. Die sich aus dieser Ansteuerung ergebenden Positionsänderungen U einer Referenzstelle auf der ersten Endfläche 11 oder der Aktuierungsfläche 1a im zeitlichen Verlauf ist in der Figur 12 dargestellt.

Bei der Ausführungsform der Figur 11 ist das erste Spannungssignal S10 zusätzlich aus einer direkt aufeinander folgenden Abfolge der Signalabschnitts-Gruppen G1, oder in einem speziellen Fall bei anderer Wahl des Startpunkts des ersten Spannungssignals S10 aus einer direkt aufeinander folgenden Abfolge der Signalabschnitts-Gruppen G2 gebildet.

Bei dem in der Figur 11 dargestellten ersten Spannungssignal S10 oder den Signalabschnitts-Gruppen G1 desselben weist die ansteigende Signalflanke S11 betragsmäßig eine geringere Steigung als die abfallende Signalflanke S12 auf. Im zeitlichen Verlauf innerhalb einer Signalabschnitts-Gruppe G1 erfolgt dadurch während der ansteigenden Signalflanke S11 eine zeitlich langsamere Veränderung des Formzustands oder der Deformation des Aktors 1 als während der abfallenden Signalflanke S12. Dabei ist der Betrag der Steigung der ansteigenden Signalflanke S11 derart eingestellt, dass aufgrund der durch diese bewirkten Geschwindigkeit der Veränderung des Formzustands des Aktors 1 eine Haftreibung zwischen dem an der Aktuierungsfläche 1a angeordneten Friktionselement F und der Friktionsfläche 90a des anzutreibenden Elements 90, an der das Friktionselement F anliegt, resultiert. In diesem Zeitabschnitt verändert sich mit der Veränderung des Formzustands des Aktors 1 die Position der Kontaktfläche FK (Figur 19) des Friktionselements F, die an der Friktionsfläche 90a des anzutreibenden Elements 90 anliegt, und somit die Position des anzutreibenden Elements 90 in einer ersten Antriebsrichtung, da dieses aufgrund der bestehenden Haftreibung von der Kontaktfläche des Friktionselements F mitgenommen wird. Auf diese Weise wird ein Vortrieb des anzutreibenden Elements 90 in der ersten Antriebsrichtung erreicht.

Weiterhin ist der Betrag der Steigung der abfallenden Signalflanke S12 derart eingestellt, dass aufgrund der durch diese bewirkten und vergleichsweise höheren Geschwindigkeit der Veränderung des Formzustands des Aktors 1 keine Haftreibung zwischen dem Friktionselement F und der Friktionsfläche 90a auftritt, sondern Gleitreibung resultiert. In dem Zeitabschnitt der abfallenden Signalflanke S12 ist die Trägheit des anzutreibenden Elements 90 relativ zu der Reibungskraft, die zwischen der Kontaktfläche FK des Friktionselements F, die an der Friktionsfläche 90a des anzutreibenden Elements 90 anliegt, und der Friktionsfläche 90a auftritt, so groß, dass sich mit der vergleichsweise schnellen Veränderung des Formzustands des Aktors 1 und der Position der Kontaktfläche FK des Friktionselements F eine Relativbewegung und somit Gleitreibung zwischen der Kontaktfläche FK und der Friktionsfläche 90a des anzutreibenden Elements 90 ergibt. In diesem Zeitabschnitt erfolgt somit kein Vortrieb des anzutreibenden Elements 90, jedoch eine Rückführbewegung der Kontaktfläche FK des Friktionselements F relativ zur Friktionsfläche 90a des anzutreibenden Elements 90. Nach Erreichen des zeitlichen Endes der Signalflanke S12 kann wiederum eine ansteigende Signalflanke S11 einer weiteren Signalabschnitts-Gruppe G1 angeschlossen werden, um erneut einen Vortrieb des anzutreibenden Elements 90 zu erreichen.

Generell ist bei einem Spannungssignal S10 zur Bewerkstelligung einer ersten Antriebsrichtung eine Signalabschnitts-Gruppe G1 so gestaltet,
(a) dass der erste Signalabschnitt SA1 zumindest einen Abschnitt aufweist, der eine Steigung hat, mit welcher eine Bewegungsgeschwindigkeit des Friktionselements F resultiert, bei der ein Haftreibungs-Zustand zwischen dem an der Aktuierungsfläche 1a angeordneten Friktionselement F und der Friktionsfläche 90a des anzutreibenden Elements 90, an der das Friktionselement F anliegt, auftritt,
(b) dass der zweite Signalabschnitte SA2 an jeder Stelle betragsmäßig eine Steigung hat, mit welcher eine Bewegungsgeschwindigkeit des Friktionselements F resultiert, bei der ein Gleitreibungs-Zustand zwischen dem an der Aktuierungsfläche 1a angeordneten Friktionselement F und der Friktionsfläche 90a des anzutreibenden Elements 90, an der das Friktionselement F anliegt, auftritt.

Das Friktionselement F nimmt hinsichtlich seiner Form oder seiner Lage oder beider Aspekte einen Neutralzustand ein, wenn sich der Aktor 1 in einem Neutralzustand befindet. Sowohl im ersten Signalabschnitt SA1, als auch dem zweiten Signalabschnitt SA2 nimmt das Friktionselement F gegenüber dem Neutralzustand in seiner Lage oder auch seinem Formzustand einen Bewegungszustand ein. Der Zwischenabschnitt S13, der zwischen dem ersten Signalabschnitt SA1 und dem zweiten Signalabschnitt SA2 gelegen ist, ist bei den Ausführungsformen des erfindungsgemäßen Verfahrens ein Signal-Abschnitt, in dem keine oder nur eine im Vergleich zum ersten und zweiten Signalabschnitt SA1, SA2 wesentlich geringere Veränderung des Formzustands des Aktors 1 erfolgt. Während eine Signalstärke eines Zwischenabschnitts S13 anliegt, kann eine Rückbildung des Friktionselements F und gegebenenfalls des Friktionselements F zusammen mit einer Halterungsvorrichtung, in der der Aktor 1 aufgenommen ist, von einem jeweils momentanen Bewegungszustand in den Neutralzustand erfolgen, bevor das Friktionselement F wiederum in einen Bewegungszustand gebracht wird, sobald der Aktor 1 mit dem ersten Signalabschnitt SA1 oder dem zweiten Signalabschnitt SA2 angesteuert wird.

Eine spezielle Ausführungsform des im erfindungsgemäßen Verfahren verwendeten ersten Spannungssignals S10 zur Erzeugung der ersten Antriebsrichtung des anzutreibenden Elements 90 weist durch einen entsprechenden Startpunkt für das ersten Spannungssignals S10 eine Mehrzahl von Signalabschnitts-Gruppen G2 jeweils bestehend aus der Abfolge einer betragsmäßig abfallenden Signalflanke S12, eines zeitlich direkt anschließenden Zwischenabschnitts S13 und einer zeitlich direkt anschließenden betragsmäßig ansteigenden Signalflanke S11 auf, wobei die ansteigende Signalflanke S11 betragsmäßig eine geringere Steigung als die abfallende Signalflanke S12 aufweist. Bei dieser Ausführungsform des ersten Spannungssignals S10 folgt beim Auftreten einer solchen Signalabschnitts-Gruppe G2 und einer nach dieser Signalabschnitts-Gruppe zeitlich nächsten abfallenden Signalflanke nicht notwendigerweise das Auftreten einer ebensolchen Gruppe. So können bei dem ersten Spannungssignal S10 nach einer abfallenden Signalflanke S12 auch andere Signalabschnitte zeitlich folgen, die keinen nach der Erfindung definierten Zwischenabschnitt S13 aufweisen. Auch kann bei einem ersten Spannungssignal S1 auf eine betragsmäßig abfallende Signalflanke S12 zeitlich direkt eine ansteigende Signalflanke S11 folgen. Nach einer Ausführungsform des erfindungsgemäßen Verfahrens kann das erste Spannungssignal S10 jedoch auch mehrere solche Gruppen aufweisen, die zeitlich aufeinander folgen. Die Signalabschnitts-Gruppe G2 kann insbesondere eine Sägezahn-Form oder eine Trapez-Form haben.

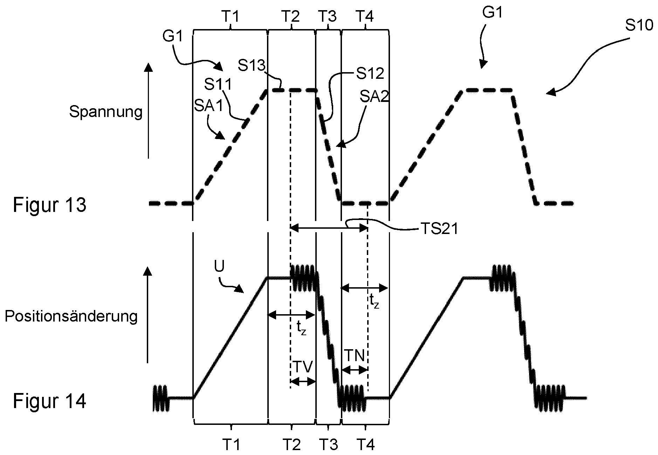

Mit den Figuren 13 und 14 wird beispielartig für die erfindungsgemäßen Ausführungsformen des Verfahrens verdeutlicht, dass das Aufschalten des zweiten Spannungssignals S20 derart erfolgt, dass der relativ hochfrequente Signalabschnitt S21 bereits in dem zeitlichen Zwischenabschnitt S13 des an dem Aktor 1 anliegenden Spannungssignals S10 erfolgt und einen Zeitabschnitt TV in diesem anliegt. Weiterhin liegt der Signalabschnitt S21 des Spannungssignals S20 noch im nachfolgenden Zwischenabschnitt und nur einen Zeitabschnitt TN in diesem an.

Eine weitere exemplarische Ausführungsform mit einer Ansteuerung eines Aktors 1, der drei Ansteuerabschnitte A1, A2, A3 aufweist, mit dem ersten Spannungssignal S10 und dem zweiten Spannungssignal S20 ist in der Figur 15 gezeigt. Bei dem in der Figur 15 dargestellten ersten Spannungssignal S10 oder den Signalabschnitts-Gruppen G1 desselben weist die ansteigende Signalflanke S11 betragsmäßig eine größere Steigung als die abfallende Signalflanke S12 auf. Im zeitlichen Verlauf innerhalb einer Signalabschnitts-Gruppe G1 erfolgt dadurch während der ansteigenden Signalflanke S11 eine zeitlich schnellere Veränderung des Formzustands oder der Deformation des Aktors 1 als während der abfallenden Signalflanke S12. Dabei ist der Betrag der Steigung der ansteigenden Signalflanke S11 derart eingestellt, dass aufgrund der durch diese bewirkten Geschwindigkeit der Veränderung des Formzustands des Aktors 1 keine Haftreibung zwischen dem an der Aktuierungsfläche 1a angeordneten Friktionselement F und der Friktionsfläche 90a des anzutreibenden Elements 90, an der das Friktionselement F anliegt, auftritt, sondern ein Gleitreibungszustand resultiert. In dem Zeitabschnitt der ansteigenden Signalflanke S11 ist die Trägheit des anzutreibenden Elements 90 relativ zu der Reibungskraft, die zwischen der Kontaktfläche FK des Friktionselements F, die an der Friktionsfläche 90a des anzutreibenden Elements 90 anliegt, und der Friktionsfläche 90a auftritt, nämlich so groß, dass sich mit der vergleichsweise schnellen Veränderung des Formzustands des Aktors 1 und der Position der Kontaktfläche FK des Friktionselements F eine Relativbewegung zwischen der Kontaktfläche FK und der Friktionsfläche 90a des anzutreibenden Elements 90 ergibt. In diesem Zeitabschnitt erfolgt somit kein Vortrieb des anzutreibenden Elements 90, sondern eine zu der Antriebsrichtung entgegen gesetzt gerichtete und für den Antrieb wirkungslose Relativbewegung zwischen der Kontaktfläche FK des Friktionselements F und der Friktionsfläche 90a des anzutreibenden Elements 90 .

Generell ist bei einem Spannungssignal S10 zur Bewerkstelligung der zweiten Antriebsrichtung eine Signalabschnitts-Gruppe G1 so gestaltet,
(a) dass der erste Signalabschnitt SA1 zumindest abschnittsweise und insbesondere an jeder Stelle betragsmäßig eine Steigung hat, mit der eine Bewegungsgeschwindigkeit des Friktionselements F resultiert, bei der ein Gleitreibungs-Zustand zwischen dem an der Aktuierungsfläche 1a angeordneten Friktionselement F und der Friktionsfläche 90a des anzutreibenden Elements 90, an der das Friktionselement F anliegt, auftritt,
(b) dass der zweite Signalabschnitt SA2 zumindest einen Abschnitt aufweist, der eine Steigung hat, mit welcher eine Bewegungsgeschwindigkeit des Friktionselements F resultiert, bei der ein Haftreibungs-Zustand zwischen dem an der Aktuierungsfläche 1a angeordneten Friktionselement F und der Friktionsfläche 90a des anzutreibenden Elements 90, an der das Friktionselement F anliegt, auftritt.

Eine spezielle Variante des dabei verwendeten ersten Spannungssignals S10 zur Erzeugung der zweiten Antriebsrichtung des anzutreibenden Elements 90 weist durch einen entsprechenden Startpunkt des ersten Spannungssignals S10 eine Mehrzahl von Signalabschnitts-Gruppen G2 jeweils bestehend aus der Abfolge einer betragsmäßig abfallenden Signalflanke S12, eines zeitlich direkt anschließenden Zwischenabschnitts S13 und einer zeitlich direkt anschließenden betragsmäßig ansteigenden Signalflanke S11 auf, wobei die ansteigende Signalflanke S11 betragsmäßig eine größere Steigung als die abfallende Signalflanke S12 aufweist.

Weiterhin ist der Betrag der Steigung der abfallenden Signalflanke S12 derart eingestellt, dass aufgrund der durch diese bewirkten langsameren Geschwindigkeit der Veränderung des Formzustands des Aktors 1 Haftreibung zwischen dem Friktionselement F und der Friktionsfläche 90a vorherrscht. In diesem Zeitabschnitt verändert sich mit der Veränderung des Formzustands des Aktors 1 die Position der Kontaktfläche FK (Figur 19) des Friktionselements F, die an der Friktionsfläche 90a des anzutreibenden Elements 90 anliegt, und somit die Position des anzutreibenden Elements 90 in einer zweiten und zur ersten Antriebsrichtung entgegengesetzten Antriebsrichtung, da dieses aufgrund der bestehenden Haftreibung von der Kontaktfläche des Friktionselements F mitgenommen wird. Auf diese Weise wird während des Anliegens der abfallenden Signalflanke S12 ein Vortrieb des anzutreibenden Elements 90 in der zweiten Antriebsrichtung erreicht, die entgegen gesetzt zu der ersten Antriebsrichtung gerichtet ist, die aufgrund der in den Figuren 11 und 12 erzeugten Signale bewirkt wird.

Nach Erreichen des zeitlichen Endes der Signalflanke S12 kann wiederum eine ansteigende Signalflanke S11 einer weiteren Signalabschnitts-Gruppe G1 angeschlossen werden, um erneut einen Vortrieb des anzutreibenden Elements 90 zu erreichen. Bei der Ausführungsform der Figur 13 ist das erste Spannungssignal S10 zusätzlich aus einer direkt aufeinander folgenden Abfolge der Signalabschnitts-Gruppe G1 gebildet.

Der hochfrequente Signalabschnitt S21 des zweiten Spannungssignals S20 beginnt bei den erfindungsgemäßen Ausführungsformen des Verfahrens zeitlich innerhalb des Zeitintervalls t_{z} in den Zwischenabschnitten S13 und erstreckt sich über die sich an diese jeweils anschließende fallende Signalflanke S12 und auch noch über einen Teil des sich an diese jeweils anschließenden Zwischenabschnitts S13. Die sich aus dieser Ansteuerung ergebenden Positionsänderungen U einer Referenzstelle auf der erste Endfläche 11 oder der Aktuierungsoberfläche 1a, insbesondere an der das Friktionselement F angeordnet ist, ist im zeitlichen Verlauf in der Figur 16 dargestellt. Durch das Aufschalten des zweiten Spannungssignals S20 während eines Zwischenabschnitts S13 des ersten Spannungssignals S10 wird die Reibung zwischen dem an der Aktuierungsfläche 1a angeordneten Friktionselement F und der Friktionsfläche 90a des anzutreibenden Elements 90, an der das Friktionselement F anliegt, reduziert. Durch das Aufschalten des zweiten Spannungssignals S20 in einem Zwischenabschnitt S13, der zeitlich vor einem Signalabschnitt SA1, SA2 mit einer Signalflanke mit einem Steigungsbetrag gelegen ist, bei dem keine Haftreibung und somit Gleitreibung zwischen dem Friktionselement F und der Friktionsfläche 90a auftritt, wird bereits vor dem Anliegen dieses jeweiligen Signalabschnitts SA1, SA2 eine Reduktion der Reibung zwischen dem Friktionselement F und der Friktionsfläche 90a bewirkt. Da auf diese Weise schon im zeitlichen Beginn dieses jeweiligen Signalabschnitts SA1, SA2 die Reibung verringert ist, wird in optimierter Weise sichergestellt, dass das Friktionselement F die Friktionsfläche 90a nicht mitbewegt bei einem Wechsel von der Haft- in die Gleitreibungsphase. Dadurch wird die Genauigkeit der durch das Friktionselement F erzeugten Bewegung des anzutreibenden Elements 90 optimiert.

Bei allen Ausführungsformen des erfindungsgemäßen Verfahrens kann vorgesehen sein, dass die betragsmäßig ansteigenden Signalflanken S11 des ersten Spannungssignals S10 linear verlaufen und somit positive und zeitlich konstante Steigung haben. Dabei können mehrere Gruppen G1 und G2 und insbesondere eine direkte Aufeinanderfolge von Gruppen G1, von Gruppen G2 oder wechselweise von Gruppen G1 und G2 ansteigende Signalflanken S11 aufweisen, die linear verlaufen und somit positive und zeitlich konstante Steigung haben. Dabei können die ansteigenden Signalflanken S11 jeweils dieselbe Steigung haben.

Alternativ oder zusätzlich dazu kann bei den Ausführungsformen des im erfindungsgemäßen Verfahren verwendeten ersten Spannungssignals S10 betragsmäßig abfallende Signalflanken S12 aufweisen, die linear verlaufen und somit negative und zeitlich konstante Steigung haben. Dabei können mehrere Gruppen G1 und G2 und insbesondere eine direkte Aufeinanderfolge von Gruppen G1, von Gruppen G2 oder wechselweise von Gruppen G1 und G2 abfallende Signalflanken S12 aufweisen, die linear verlaufen und somit negative und zeitlich konstante Steigung haben. Dabei können die abfallenden Signalflanken S12 jeweils dieselbe Steigung haben.

Eine Ausführungsform des im erfindungsgemäßen Verfahren verwendeten ersten Spannungssignals S10 kann Zwischenabschnitte S13 aufweisen, die linear verlaufen. Dabei können mehrere Gruppen G1 und G2 und insbesondere eine direkte Aufeinanderfolge von Gruppen G1, von Gruppen G2 oder wechselweise von Gruppen G1 und G2 Zwischenabschnitte S13 aufweisen, die linear verlaufen. Dabei kann jeweils vorgesehen sein, dass der Zwischenabschnitt S13 ein Abschnitt mit einer Steigung sein, der abschnittsweise oder, wie in den Beispielen der Figuren 11 und 13 gezeigt, durchweg den Wert Null hat.

Die Ansteuerung des zweiten Ansteuerabschnitts A2 mit dem zweiten Spannungssignal S20 beginnt nach der Erfindung zeitlich innerhalb des Zeitintervalls t_{z} des Signal-Zwischenabschnitts S13 des ersten Spannungssignals S10, der insbesondere um einen Zeitabschnitt TZ vor einer Signalflanke gelegen ist, die zu einer Relativbewegung zwischen dem an der Aktuierungsfläche 1a angeordneten Friktionselement F und der Friktionsfläche 90a des anzutreibenden Elements 90 führt.

Insbesondere wenn aus der zeitlichen Aufeinanderfolge von zwei Signal-Zwischenabschnitten S13 jeweils nach einer ansteigenden Signalflanke S11 oder jeweils einer abfallenden Signalflanke S12 eine Frequenz des ersten Spannungssignals S10 definiert ist, so kann die Frequenz des zweiten Spannungssignals S20 zumindest in diesen Signal-Zwischenabschnitten S13 im Vergleich zu der auf diese Weise definierten Frequenz des ersten Spannungssignals S10 um einen Faktor von wenigstens 10 mal höher sein.

Generell kann der hochfrequente Signalabschnitt S21 des zweiten Spannungssignals S20 sinusförmig gebildet sein.

Nach einer Ausführungsform des erfindungsgemäßen Verfahrens, insbesondere in Verbindung mit einem der zuvor beschriebenen Merkmale desselben, beginnt das zweite Spannungssignal S20 zu einem Zeitpunkt, der zeitlich nach Verstreichen von wenigstens 10% und maximal 90% des Zeitintervalls t_{z} des Signal-Zwischenabschnitts S13 liegt. Alternativ oder zusätzlich erfolgt der Beginn des zweiten Spannungssignals S20 zu einem Zeitpunkt, der 50% des Zeitintervalls des Signal-Zwischenabschnitts S13 vor Ende desselben liegt.

Nach einer Ausführungsform des erfindungsgemäßen Verfahrens, insbesondere in Verbindung mit einem der zuvor beschriebenen Merkmale desselben erstreckt sich das zweite Spannungssignal S20 über einen zeitlich direkt anschließenden oder zeitlich benachbarten Signalabschnitt SA1 mit einer ansteigenden Signalflanke S11 ununterbrochen hinweg bis zu einem zeitlich nachfolgenden Signal-Zwischenabschnitt 13 und endet insbesondere mit Ablauf eines Zeitabschnitts TN innerhalb des Zeitintervalls t_{z} dieses Signal-Zwischenabschnitt 13 oder mit seinem Ende. Auch kann sich das zweite Spannungssignal S20 nach einer Ausführungsform des erfindungsgemäßen Verfahrens, insbesondere in Verbindung mit einem der zuvor beschriebenen Merkmale desselben, über einen zeitlich direkt anschließenden oder zeitlich benachbarten Signalabschnitt SA2 mit einer abfallenden Signalflanke S12 ununterbrochen hinweg bis zu einem zeitlich nachfolgenden Signal-Zwischenabschnitt 13 erstrecken und innerhalb des Zeitintervalls t_{z} dieses Signal-Zwischenabschnitt 13 oder mit seinem Ende enden.

Nach einer Ausführungsform des erfindungsgemäßen Verfahrens, insbesondere in Verbindung mit einem der zuvor beschriebenen Merkmale desselben, beträgt die maximale Amplitude des zweiten Spannungssignals S20 höchstens 50% der maximalen Amplitude des ersten Spannungssignals S10.

Nach einer weiteren Ausführungsform des erfindungsgemäßen Verfahrens, insbesondere in Verbindung mit einem der zuvor beschriebenen Merkmale desselben, erfolgt
(a) bei dem Ansteuern des ersten Ansteuerabschnitts A1 ein gleichzeitiges Ansteuern von mehreren ersten Ansteuer-Teilabschnitten, die den ersten Ansteuerabschnitt A1 bilden und in der Längsrichtung L hintereinander gelegen sind, mit dem ersten Spannungssignal S10,
(a) bei dem Ansteuern des zweiten Ansteuerabschnitts A2 ein gleichzeitiges Ansteuern von mehreren zweiten Ansteuer-Teilabschnitten, die den zweiten Ansteuerabschnitt A2 bilden und in der Längsrichtung L hintereinander gelegen sind, mit dem zweiten Spannungssignal S20.

Nach einer weiteren Ausführungsform des erfindungsgemäßen Verfahrens, insbesondere in Verbindung mit einem der zuvor beschriebenen Merkmale desselben, erfolgt gleichzeitig mit der Ansteuerung des ersten Ansteuerabschnitts A1 mit dem ersten Spannungssignal ein Ansteuern eines durch eine elektrische Spannung deformierbaren dritten Ansteuerabschnitts A3 mit dem ersten Spannungssignal S10, wobei der dritte Ansteuerabschnitt derart angeordnet ist, dass der zweite Ansteuerabschnitt A2 zwischen dem ersten und dem dritten Ansteuerabschnitt A3 gelegen ist.

In den Figuren 17 bis 19 ist eine Ausführungsform der Antriebsvorrichtung K gezeigt, die im Weiteren mit dem Bezugszeichen "K1" bezeichnet wird. Bei der Ausführungsform der Halterungsvorrichtung 40 der Figur 17 weist diese ein Aufnahmeteil 43 zur Aufnahme der zweiten Aktor-Endfläche FE2 des Aktors 1, ein Halteteil 44 zum Halten des Friktionselements F oder der ersten Endfläche 11 und zwei Verbindungsteile 45, 46 auf, die zueinander entlang verlaufen und das Aufnahmeteil 43 und das Halteteil 44 verbinden. Aufgrund der Lage des Aktors 1 in der Halterungsvorrichtung 40 kann eine Zentralachse Z der Antriebsvorrichtung K1 definiert sein, die entlang oder insbesondere in Richtung der Längsrichtung L des Aktors 1 verlaufen kann. Die Zentralachse Z kann dabei eine Symmetrieachse der Halterungsvorrichtung 40 oder eine Mittellachse derselben sein. Bei den anhand der Figuren 17 bis 26 beschriebenen Ausführungsformen der Antriebsvorrichtung K ist das Friktionselement F an der ersten Aktor-Endfläche FE1 gelegen, die somit die äußere Aktuierungsfläche 1a ist. Die Aktuierungsfläche 1a kann auch die Außenfläche einer auf der ersten Aktor-Endfläche FE1 gelegenen Zwischenschicht oder Strukturkomponente sein. Bei den Ausführungsformen der Figuren 17 bis 26 umgrenzen das Aufnahmeteil 43, das Halteteil 44 und die zwei Verbindungsteile 45, 46 einen Aufnahmeraum 49, in dem der Aktor 1 zusammen mit dem Friktionselement F oder die jeweiligen Ansteuerabschnitte des Aktors 1 mit dem Friktionselement F aufgenommen sind. Dabei erstreckt sich der Aktor 1 mit dem Friktionselement F in der Längsrichtung L zwischen dem Aufnahmeteil 43 und dem Halteteil 44. Das Friktionselement F ist somit innerhalb der Halterungsvorrichtung 40 oder innerhalb des Aufnahmeraums 47 angeordnet. Bei den Ausführungsformen der Figuren 17 bis 26 erstreckt sich das Friktionselement F in dessen Längsrichtung LF von einem Bereich zwischen der ersten Aktor-Endfläche FE1 und dem Halteteil 44 mit seiner Längsrichtung LF quer zur Längsrichtung L des Aktors 1 hin zu einer generell dem Friktionselement F zugewandten Friktionsfläche 90a des anzutreibenden Elements 90.

Das Halteteil 44 drückt, von der Antriebsvorrichtung K1 aus gesehen, von außen in einer Richtung, die entlang der Längsrichtung L zur Aktuierungsfläche 1a verläuft, auf das Friktionselement F. Aufgrund der Bewegungen der Aktuierungsfläche 1a, bedingt durch die durch entsprechende Spannungsbeaufschlagung und in den Figuren 4 und 5 gezeigten Deformationszustände des in dem Aktors 1, resultieren entsprechende Bewegungen des Friktionselements F, durch die das anzutreibende Element 90 bewegt werden kann.

Der erfindungsgemäße Aktor 1 kann mit der Halterungsvorrichtung 40 in einer Lagerungsvorrichtung 50 eines Motors M eingebaut oder in dieser integriert sein, wobei die Lagerungsvorrichtung räumlich feststehend, d.h. in einem räumlichen Referenzsystem stationär angeordnet ist. Bei dynamischer Verformung des Aktors 1 und der daraus resultierenden Bewegung der Aktuierungsfläche 1a bewegt sich das Friktionselement F relativ zur Lagerungsvorrichtung 50 bzw. dem räumlichen Referenzsystem und verursacht eine Bewegung des anzutreibenden Elements 90, das in Friktionskontakt mit dem Friktionselement F steht und von einer Führungsvorrichtung 95 in einer von dieser vorgegebenen Führungsbahn geführt wird. Die Führungsvorrichtung 95 ist insbesondere relativ zur Lagerungsvorrichtung 50 als einem Referenzsystem stationär angeordnet.

Die Lagerungsvorrichtung 50 weist bei der Ausführungsform gemäß Figur 17 eine Grundplatte 51 auf, die insbesondere die Funktion einer Lagerungsplatte oder Verbindungsplatte haben kann.

Die Lagerungsvorrichtung 50 kann eine Vorspannvorrichtung 60 aufweisen, die eine Kraft auf die Antriebsvorrichtung K bzw. auf das Friktionselement F ausübt, die von der Grundplatte 51 zum Friktionselement F gerichtet ist und dieses an das anzutreibende Element 90 drückt. Bei der Ausführungsform der Antriebsvorrichtung K der Figur 17 ist die Vorspannvorrichtung 60 als Platte 64 oder Federplatte ausgeführt, die mit einem ersten Endabschnitt 65 an der Grundplatte 61 befestigt ist. Die Platte 64 ist derart an der Grundplatte 51 der Lagerungsvorrichtung 50 gelegen, dass ein entgegen gesetzt zu dem ersten Endabschnitt 65 gelegener zweiter Endabschnitt 66 an dem Friktionselement F anliegt und das Friktionselement F mit einer Druckkraft gegen das anzutreibende Element 90 drückt, wenn die Antriebsvorrichtung K in einem Motor M eingebaut ist. Wie in der Figur 17 gezeigt, kann der Aktor 1 zumindest teilweise in einer Ausnehmung 57 der Grundplatte 51, die eine zu dem anzutreibenden Element 90 hin offene Vertiefung oder eine Durchgangs-Öffnung sein kann, gelegen sein, wobei die Platte 64 von einem Randabschnitt der Ausnehmung 57 aus in die Ausnehmung 57 hineinragt, in der der zweite Endabschnitt 66 an dem Friktionselement F anliegt. Alternativ oder zusätzlich kann die Vorspannvorrichtung 60 als Druckfeder ausgeführt sein, die zwischen der Grundplatte 51 und dem Friktionselement F oder gegebenenfalls zwischen der Platte 64 und dem Friktionselement F gelegen ist.

Ein Motor M mit einer Antriebsvorrichtung K und der Lagerungsvorrichtung 50 ist schematisch in den Figuren 17 bis 22 gezeigt, in denen der Aktor 1 jeweils schematisch dargestellt ist. Die Lagerungsvorrichtung 50 kann auch anders realisiert sein und z.B. als eine Befestigungsvorrichtung ausgeführt sein. In dem Motor M nach der Erfindung kann eine hierin beschriebene Ausführungsform des Aktors 1 eingebaut oder integriert sein. Der Motor M weist die Antriebsvorrichtung K, das anzutreibende Element 90 und eine Führungsvorrichtung 95 auf, die strukturell und statisch mit der Grundplatte 51 in Verbindung steht, so dass sich das anzutreibende Element 90 aufgrund der Verformungen des Aktors 1 und der Bewegung des Friktionselements F relativ zur Grundplatte 51 bewegen kann.

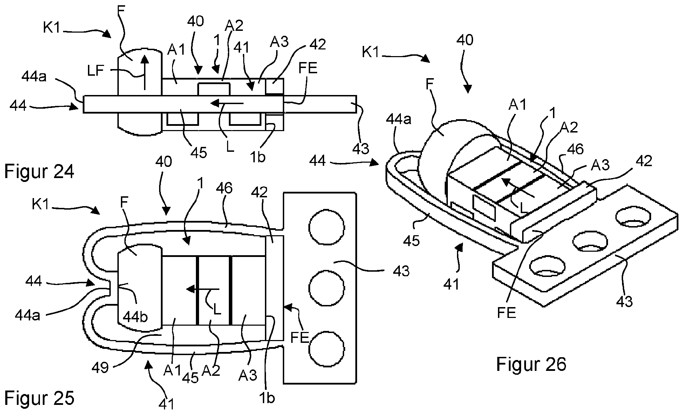

Die Figuren 17 bis 22 zeigen eine Ausführungsform des Motors M, bei der ein Aktor 1 mit drei in der Längsrichtung L hintereinander angeordneten Ansteuerabschnitten A1, A2, A3 strukturell integriert ist. In den Figuren 24 bis 26 ist die darin verwendete Antriebsvorrichtung K mit einem solchen Aktor 1 als Einzelheit dargestellt. Bei den anhand der Figuren 17 bis 26 beschriebenen Ausführungsformen ist das Friktionselement F an der ersten Endfläche 11 des ersten Ansteuerabschnitts A1 als erste Aktor-Endfläche FE1 gelegen, die somit die äußere Aktuierungsfläche 1a ist.

Bei einer weiteren Ausführungsform kann das Friktionselement F an einer Außenfläche 44a des Halteteils 44 der Halterungsvorrichtung 40 als Aktuierungsfläche 1a gelegen sein, die entgegen gesetzt zu einer Innenfläche 44b des Halteteils 44 orientiert ist, an der der Aktor 1 anliegt. Dabei kann insbesondere vorgesehen sein, dass das Friktionselement F an dem Halteteil 44 befestigt ist. Dabei kann vorgesehen sein, dass sich das Friktionselement F mit seiner Längsrichtung LF quer zur Längsrichtung L oder entlang der Längsrichtung L des Aktors 1 hin zu einer Friktionsfläche 90a des anzutreibenden Elements 90 erstreckt.

Eine Ausführungsform der Antriebsvorrichtung K mit diesen Merkmalen ist in den Figuren 27 bis 30 dargestellt. Diese ist im Weiteren mit dem Bezugszeichen "K2" bezeichnet. Der Aktor 1 kann dabei nach einer der hierin beschriebenen Ausführungsformen realisiert sein.

Die in den Figuren 27 bis 30 dargestellte Ausführungsform der Antriebsvorrichtung K2 umfasst eine Halterungsvorrichtung 240, die aufweist: ein sich zumindest abschnittsweise quer zur Längsrichtung L erstreckendes Aufnahmeteil 243 zur Aufnahme der zweiten Aktor-Endfläche FE2 als Lagerungsfläche 1b des Aktors 1, ein sich zumindest abschnittsweise quer zur Längsrichtung L erstreckendes Halteteil 244 zum Halten des Friktionselements F und zur Aufnahme der ersten Aktor-Endfläche FE1, und zwei Verbindungsteile 245, 246, die entlang der Längsrichtung L verlaufen und das Aufnahmeteil 243 und das Halteteil 244 verbinden. Das Aufnahmeteil 243, das Halteteil 244 und die Verbindungsteile 245, 246 bilden einen Aufnahmeraum 249, in dem der Aktor 1 gelegen ist. Dabei ist das Friktionselement F an einer Außenfläche 244a des Halteteils 244 der Halterungsvorrichtung 240 als Aktuierungsfläche 1a gelegen, die entgegen gesetzt zu einer Innenfläche 244b des Halteteils 244 orientiert ist, an der der Aktor 1 anliegt. Dabei erstreckt sich das Friktionselement F in einer Referenz- oder Neutralstellung mit seiner Längsrichtung LF in der Längsrichtung L oder entlang der Längsrichtung L des Aktors 1 hin zu der Friktionsfläche 90a des anzutreibenden Elements 90, wenn die Antriebsvorrichtung K2 in einen Motor eingebaut ist.

Es ist ebenso denkbar, dass sich das Friktionselement F mit seiner Längsrichtung LF quer zur Längsrichtung L des Aktors 1 hin zu einer Friktionsfläche 90a des anzutreibenden Elements 90 erstreckt. Dabei kann das Friktionselement F auch zwischen dem Halteteil 244 und insbesondere der Innenfläche 244b des Halteteils 244 und dem Aktor 1 angeordnet sein.

Aufgrund der Lage des Aktors 1 kann eine Zentralachse Z der Antriebsvorrichtung K2 definiert sein, die entlang oder insbesondere in Richtung der Längsrichtung L des Aktors 1 verlaufen kann. Die Zentralachse Z kann dabei eine Symmetrieachse der Halterungsvorrichtung 240 oder eine Mittellachse derselben sein. Die Verbindungsteile 245, 246 erstrecken sich entlang der Zentralachse Z. Die Verbindungsteile 245, 246 weisen jeweils eine Außenfläche 245c bzw. 246c auf, die entlang der Längsrichtung L des Aktors 1 oder der Zentralachse Z verlaufen und entgegen gesetzt zueinander orientiert sind. Das Aufnahmeteil 243, das Halteteil 244 und die Verbindungsteile 245, 246 können als ein Stück hergestellt sein. Alternativ dazu kann, wie in der Figuren 27 bis 30 gezeigt, das Halteteil 244 als ein erstes eigenes Teil und das Aufnahmeteil 243 und die Verbindungsteile 245, 246 als ein zweites eigenes Teil ausgebildet sein. Die Halterungsvorrichtung 240 kann auch derart ausgeführt sein, dass diese nur ein einzelnes Verbindungsteil 245 oder 246 aufweist. Das Aufnahmeteil 243 und das zumindest eine Verbindungsteil 245 oder 246 können als eigene Teile ausgebildet sein. Das Halteteil 244 kann insbesondere plattenförmig oder stegförmig gebildet sein. Das Aufnahmeteil 243 und das zumindest eine Verbindungsteil 245 oder 246 können insgesamt eine Hufeisen-Form bilden.

Die Halterungsvorrichtung 240 kann als Spannrahmen 241 ausgeführt sein, in den die Ansteuerabschnitte des jeweiligen Aktors 1 zwischen dem Aufnahmeteil 243 und dem Halteteil 244 eingespannt sind und dabei auf den Aktor 1 eine Einspannkraft in Form einer Druckkraft ausübt, die in der Längsrichtung L des Aktors 1 wirkt. Bei dieser Ausführungsform der Halterungsvorrichtung 240 wird mit der Einspannkraft der Aktor 1 in einen vorbestimmten in der Längsrichtung L kontrahierten Zustand, z.B. einen Referenzzustand oder einen Neutralzustand, federnd vorgespannt. Eine federnde Vorspannung des Aktors 1 ist insbesondere dadurch gegeben, dass das Halteteil 244 plattenförmig oder stegförmig ausgebildet ist. Dabei kann insbesondere das Halteteil 244 zumindest abschnittsweise aus einem elastischen Material gebildet sein. Aufgrund dieser Vorspannung wird der Aktor 1 schneller von einem expandierten Zustand in einen kontrahierten Zustand rückgeführt. Die Halterungsvorrichtung 240 ist derart ausgeführt, dass diese sich zumindest auf einer Seite des Aktors 1 über eine von der Aktuierungsfläche 1a zur Lagerungsfläche 1b verlaufende Strecke erstreckt und somit den Aktor 1 in Längsrichtung L umgibt oder umklammert.

An dem Halteteil 244 oder der Aktuierungsfläche 1a des Aktors 1 ist der erste Endabschnitt 245a eines ersten Verbindungsteils 245 und ist der zweite Endabschnitt 246a eines zweiten Verbindungsteils 246 gelegen. Bei den Ausführungsformen der Halterungsvorrichtung 240 kann vorgesehen sein, dass jeder von zwei entgegen gesetzt zueinander gelegenen Endabschnitten 247 bzw. 248 des Halteteils 244 auf dem jeweiligen Endabschnitt oder Endabschnitt 245a, 246a des zumindest einen Verbindungsteils 245 oder 246 befestigt ist, jeweils z.B. mittels eines Verbindungselements 245d bzw. 246d. Dabei kann vorgesehen sein, dass die Lage des Halteteils 244 relativ zu dem Aufnahmeteil 243 oder zu den Verbindungsteilen 245 oder 246 und insbesondere zu den Endabschnitten 245a bzw. 246a mittels einer Einstellvorrichtung einstellbar ist. Die Einstellvorrichtung kann durch die Verbindungselemente 245d bzw. 246d realisiert sein, mit denen jeweils der Abstand zu einem jeweiligen äußeren Endabschnitt 245a bzw. 246a einstellbar ist. Durch die Einstellung der Lage des Halteteils 244 relativ zu dem zumindest einen Verbindungsteil 245 oder 246 ist die auf den Aktor 1 wirkende Einspannkraft einstellbar.

Das Friktionselement F kann mittig auf der Zentralachse Z gelegen sein. Alternativ oder zusätzlich kann auch der Aktor 1 mittig auf der Zentralachse Z gelegen sein, wobei die Längsrichtung L mit der Zentralachse Z zusammenfallen kann. Generell kann die Längsrichtung L in einem Abstand zur Zentralachse Z gelegen sein, der von dem Wert Null verschieden ist. Bei der in der Figur 27 gezeigten Ausführungsform der Antriebsvorrichtung K2 ist der Aktor 1 als Ganzes seitlich der Zentralachse Z gelegen und ist das Friktionselement F mittig auf der Zentralachse Z gelegen. Bei den in den Figuren 27 bis 30 gezeigten Ausführungsformen der Antriebsvorrichtung K2 sind die Außenflächen 245c bzw. 246c symmetrisch zur Längsrichtung L des Aktors 1 angeordnet.

Bei der Ausführungsform der Antriebsvorrichtung K2 kann der Aktor 1 nach einer der hierin beschriebenen Ausführungsformen desselben realisiert sein. In der Figur 31 weist der Aktor 1 einen ersten Ansteuerabschnitt A1, zweiten Ansteuerabschnitt A2 und einen dritten Ansteuerabschnitt A3 auf.

In den Figuren 31 bis 34 ist eine Variante der Ausführungsform der Antriebsvorrichtung gemäß den Figuren 27 bis 30 dargestellt, die hierin mit dem Bezugszeichen "K3" bezeichnet wird und die eine Halterungsvorrichtung 340 umfasst, die aufweist: ein sich zumindest abschnittsweise quer zur Längsrichtung L erstreckendes Aufnahmeteil 343 zur Aufnahme der zweiten Aktor-Endfläche FE2 als Lagerungsfläche 1b des Aktors 1, ein sich zumindest abschnittsweise quer zur Längsrichtung L erstreckendes Halteteil 344 zum Halten des Friktionselements F und zur Aufnahme des ersten Ansteuerabschnitts A1 des Aktors 1 mit der ersten Endfläche 11 als erste Aktor-Endfläche FE1 und ein erstes und zweites Verbindungsteil 345, 346, die entlang der Längsrichtung L verlaufen und das Aufnahmeteil 343 und das Halteteil 344 miteinander verbinden. Dabei ist das Friktionselement F an einer Außenfläche 344a des Halteteils 344 der Halterungsvorrichtung 340 als Aktuierungsfläche 1a gelegen, die entgegen gesetzt zu einer Innenfläche 344b des Halteteils 344 orientiert ist, an der der Aktor 1 anliegt. Dabei erstreckt sich das Friktionselement F in einer Referenz- oder Neutralstellung mit seiner Längsrichtung LF in der Längsrichtung L oder entlang der Längsrichtung L des Aktors 1 hin zu der Friktionsfläche 90a des anzutreibenden Elements 90, wenn die Antriebsvorrichtung K3 in einem Motor eingebaut ist. Aufgrund der Lage des Aktors 1 kann eine Zentralachse Z der Antriebsvorrichtung K3 definiert sein, die entlang und insbesondere in Richtung der Längsrichtung L des Aktors 1 verlaufen kann. Die Zentralachse Z kann dabei eine Symmetrieachse der Halterungsvorrichtung 340 oder eine Mittellachse derselben sein. Im Folgenden werden im Wesentlichen Merkmale beschrieben, in denen sich die Antriebsvorrichtung K3 von der Antriebsvorrichtung K2 unterscheidet. An dem Halteteil 344 oder der Aktuierungsfläche 1a des Aktors 1 sind der erste Endabschnitt 345a des ersten Verbindungsteils 345 und ist der zweite Endabschnitt 346a des zweiten Verbindungsteils 346 gelegen. Das Aufnahmeteil 343, das Halteteil 344 und die Verbindungsteile 345, 346 bilden einen Aufnahmeraum 349, in dem der Aktor 1 gelegen ist. Die Außenflächen 345c, 346c der Verbindungsteile 345, 346, die entgegen gesetzt zueinander orientiert sind, verlaufen entlang der Längsrichtung L des Aktors 1 oder der Zentralachse Z.

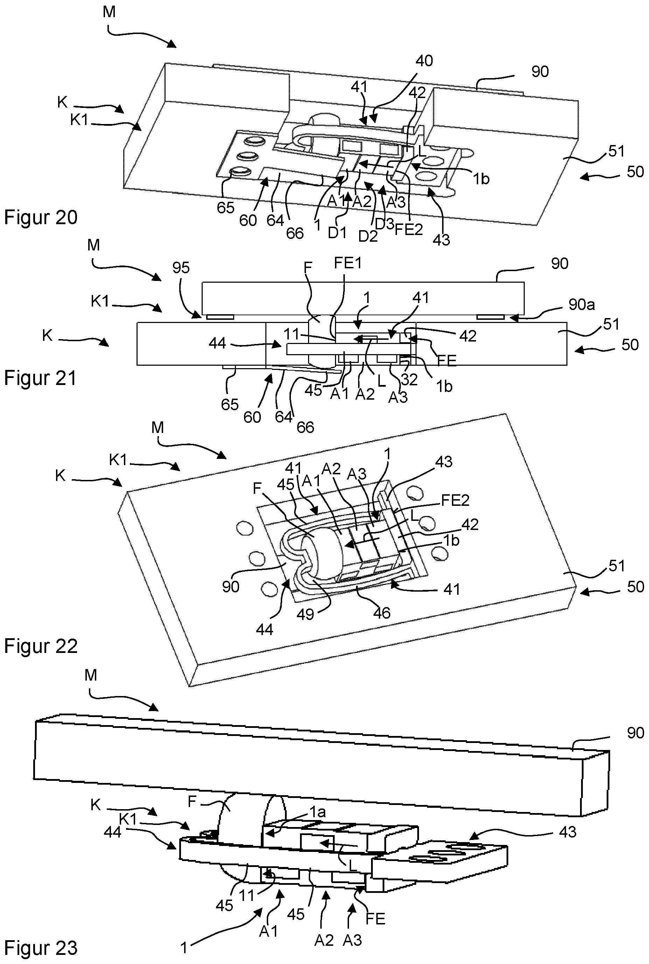

Bei der Antriebsvorrichtung K3 ist ein erster Endabschnitt 347 des Halteteils 344 über dem ersten Endabschnitt 345a des ersten Verbindungsteils 345 gelegen und erstreckt sich das Halteteil 344 quer zur Längsrichtung L von dem ersten Endabschnitt 345a des ersten Verbindungsteils 345 zu dem zweiten Endabschnitt 346a des zweiten Verbindungsteils 346. Dabei ist der erste Endabschnitt 347 des Halteteils 344 quer zu der Längsrichtung L gesehen über dem ersten Endabschnitt 345a des ersten Verbindungsteils 345 gelegen und ist der zweite Endabschnitt 348 des Halteteils 344 einstückig mit dem zweiten Endabschnitt 346a des zweiten Verbindungsteils 346 ausgebildet. Der erste Endabschnitt 347 des Halteteils 344 kann mit dem ersten Endabschnitt 345a des ersten Verbindungsteils 345 einstückig ausgebildet sein oder, wie in der Figur 22 gezeigt, über ein Verbindungselement 345d mit diesem verbunden sein. Insbesondere kann die Lage des Halteteils 344 und die Lage des Aufnahmeteils 343 derart vorgesehen sein, dass diese den Aktor 1 in seiner Längsrichtung L einspannen und auf den Aktor 1 eine Einspannkraft in Form einer Druckkraft ausüben, die in der Längsrichtung L des Aktors 1 wirkt. Dabei kann der erste Endabschnitt 347 des Halteteils 344 mit dem ersten Endabschnitt 345a des ersten Verbindungsteils 345 mittels einer Einstellvorrichtung verbunden sein. Diese kann durch ein Verbindungselement realisiert sein, mit dem der Abstand zwischen dem ersten Endabschnitt 347 des Halteteils 344 und dem ersten Endabschnitt 345a des ersten Verbindungsteils 345 einstellbar ist, um auf den Aktor 1 eine in der Längsrichtung L wirkende Einspannkraft bzw. Druckkraft einzustellen.

Das Friktionselement F ist auf einer Erhöhung 344e der Außenseite 344a des Halteteils 344 angeordnet. Bei der Ausführungsform der Antriebsvorrichtung K3, die in den Figuren 22 bis 23 gezeigt ist, ist das Friktionselement F mittig auf der Zentralachse Z gelegen. Dabei erstreckt sich das Friktionselement F mit seiner Längsrichtung LF in der Längsrichtung L oder entlang der Längsrichtung L des Aktors 1 hin zu der Friktionsfläche 90a des anzutreibenden Elements 90, wenn die Antriebsvorrichtung K3 in einem Motor M eingebaut ist. Alternativ dazu kann vorgesehen sein, dass sich das Friktionselement F mit seiner Längsrichtung LF quer zur Längsrichtung L des Aktors 1 hin zu einer Friktionsfläche 90a des anzutreibenden Elements 90 erstreckt. Dabei kann das Friktionselement F auch zwischen dem Halteteil 344 und insbesondere der Innenfläche 344b des Halteteils 344 und dem Aktor 1 angeordnet sein.

Die Antriebsvorrichtung K3 kann Merkmale der Antriebsvorrichtung K2 und umgekehrt aufweisen.

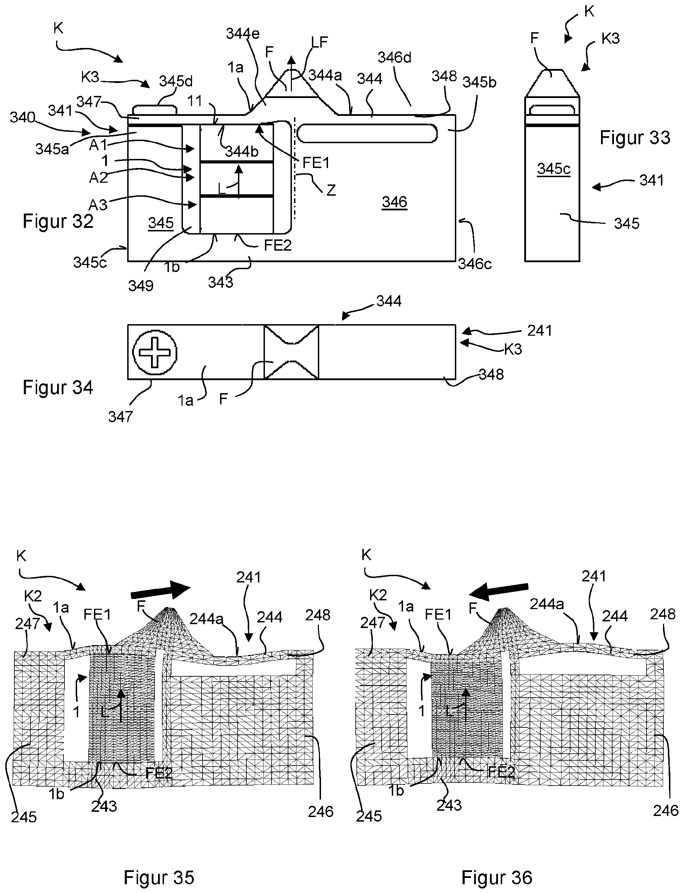

Bei einer elektrischen Ansteuerung des Aktors 1 mit entsprechenden Spannungssignalen einer Signalerzeugungs-Vorrichtung V können die Antriebsvorrichtungen K2 und K3 gemäß den Figuren 27 bis 34 die in den Figuren 35 und 36 dargestellten und anhand von FEM-Simulationen berechneten Verformungszustände einnehmen, und durch periodisches Wechseln von einem dieser Deformationszustände zu dem jeweils anderen Deformationszustand ist eine Bewegung des Friktionselements F realisierbar, die zu einem Antrieb eines damit in Friktionskontakt gelangenden anzutreibenden Elements nutzbar ist.

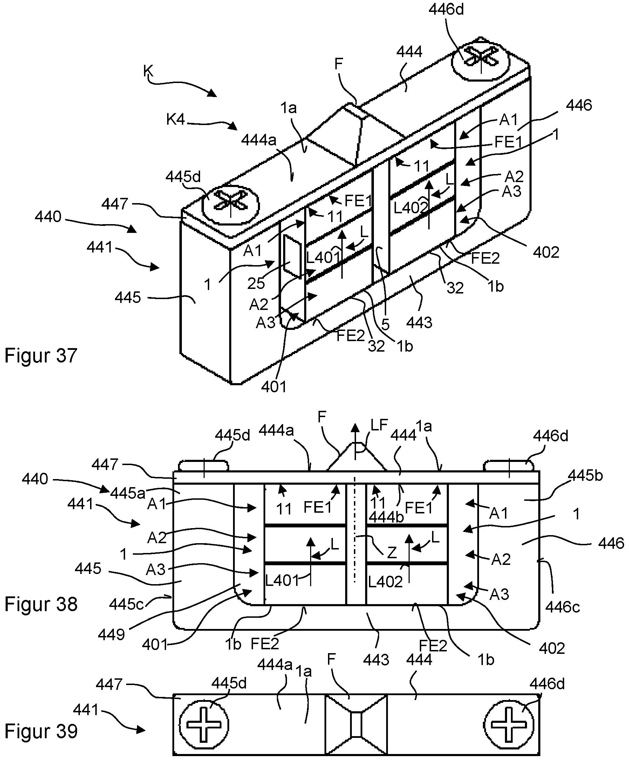

Die Figuren 37 bis 39 zeigen eine weitere Ausführungsform für eine erfindungsgemäße Antriebsvorrichtung, die hierin mit dem Bezugszeichen "K4" bezeichnet wird. Die Antriebsvorrichtung K4 weist zwei Aktoren 401 und 402 auf, die jeweils wie der Aktor 1 nach der Figur 8 ausgeführt sind und für die die Bezugszeichen desselben verwendet werden. Für die Längsrichtung L der Aktoren 401, 402 werden konkret die Bezugszeichen "L401" bzw. "L402" verwendet. Weiterhin weist die Antriebsvorrichtung K4 eine Halterungsvorrichtung 440 auf, die umfasst: ein sich zumindest abschnittsweise quer zu den Längsrichtungen L401, L402 erstreckendes Aufnahmeteil 443 zur Aufnahme der zweiten Aktor-Endflächen FE2 als Lagerungsflächen 1b der Aktoren 401, 402, ein sich zumindest abschnittsweise quer zu den Längsrichtungen L401, L402 erstreckendes Halteteil 444 zum Halten des Friktionselements F und zur Aufnahme der ersten Ansteuerabschnitte A1 oder der ersten Aktor-Endflächen FE1 der Aktoren 401, 402 und ein erstes und zweites Verbindungsteil 445, 446, die entlang der Längsrichtung L verlaufen und das Aufnahmeteil 443 und das Halteteil 444 verbinden. Dabei ist das Friktionselement F an einer Außenfläche 444a des Halteteils 444 der Halterungsvorrichtung 40 als Aktuierungsfläche 1a gelegen, die entgegen gesetzt zu einer Innenfläche 444b des Halteteils 444 orientiert ist, an der der Aktor 1 anliegt. Dabei erstreckt sich das Friktionselement F in einer Referenz- oder Neutralstellung mit seiner Längsrichtung LF in der Längsrichtung L oder entlang der Längsrichtung L des Aktors 1 hin zu der Friktionsfläche 90a des anzutreibenden Elements 90, wenn die Antriebsvorrichtung K4 in einem Motor eingebaut ist. Aufgrund der Lage der Aktoren 401, 402 kann eine Zentralachse Z der Antriebsvorrichtung K4 definiert sein, die entlang und insbesondere in Richtung der Längsrichtungen L401, L402 des Aktors 1 verlaufen kann. Die Zentralachse Z kann dabei eine Symmetrieachse der Halterungsvorrichtung 40 oder eine Mittellachse derselben sein.

Im Folgenden werden im Wesentlichen Merkmale beschrieben, in denen sich die Antriebsvorrichtung K4 von der Antriebsvorrichtung K2 unterscheidet. An dem Halteteil 444 oder der Aktuierungsfläche 1a des Aktors 1 ist ein erster Endabschnitt 445a eines ersten Verbindungsteils 445 und ist ein zweiter Endabschnitt 446a eines zweiten Verbindungsteils 446 gelegen. Das Aufnahmeteil 443, das Halteteil 444 und die Verbindungsteile 445, 446 bilden einen Aufnahmeraum 449, in dem die Aktoren 401, 402 gelegen sind. Dabei verlaufen die Längsrichtungen L401, L402 der Aktoren 401, 402 zueinander parallel. Generell verläuft die Längsrichtung L401 entlang der Längsrichtung L402. Die Außenflächen 445c, 446c der Verbindungsteile 445, 446, die entgegen gesetzt zueinander orientiert sind, verlaufen entlang der Längsrichtungen L401, L402 der Aktoren 401, 402 oder der Zentralachse Z.

Das Halteteil 444 der Antriebsvorrichtung K4 kann jegliche Form haben und ist bei der gezeigten Ausführungsform plattenförmig oder stegförmig gebildet. Ein erster Endabschnitt 447 des Halteteils 444 ist über dem ersten Endabschnitt 445b und ein zweiter Endabschnitt 448 des Halteteils 444 ist über dem zweiten Endabschnitt 446b gelegen. Dabei ist der erste Endabschnitt 447 des Halteteils 444 in der Längsrichtung L401 gesehen über dem ersten Endabschnitt 445b des ersten Verbindungsteils 445 gelegen und ist der zweite Endabschnitt 448 des Halteteils 444 in der Längsrichtung L402 gesehen über dem zweiten Endabschnitt 446b des zweiten Verbindungsteils 446 gelegen. Eines oder beide der Endabschnitte 447, 448 des Halteteils 444 können mit dem jeweiligen Endabschnitt 445b, 446b einstückig ausgebildet sein oder, wie in den Figuren 37 bis 39 gezeigt, jeweils über ein Verbindungselement 445d, 446d mit dem jeweiligen Endabschnitt 445b, 446b verbunden sein. Insbesondere kann die Lage des Halteteils 444 und die Lage des Aufnahmeteils 443 derart vorgesehen sein, dass diese die Aktoren 401, 402 in ihren Längsrichtungen L401, L402 einspannen und auf die Aktoren 401, 402 jeweils eine Einspannkraft in Form einer Druckkraft ausüben, die entlang der Längsrichtungen L401, L402 der Aktoren 401, 402 wirkt. Dabei kann der erste Endabschnitt 447 des Halteteils 444 mit dem ersten Endabschnitt 445b des ersten Verbindungsteils 445 mittels einer Einstellvorrichtung verbunden sein. Diese kann durch ein Verbindungselement realisiert sein, mit dem der Abstand zwischen dem ersten Endabschnitt 447 des Halteteils 444 und dem ersten Endabschnitt 445b des ersten Verbindungsteils 445 einstellbar ist, um auf die Aktoren 401, 402 eine in den Längsrichtungen L401, L402 wirkende Einspannkraft bzw. Druckkraft einzustellen.

Generell können Längsrichtungen L401, L402 in einem Abstand zur Zentralachse Z gelegen sein, der von dem Wert Null verschieden ist. Die Aktoren 401, 402 können als Ganzes jeweils seitlich und auf einander gegenüber liegenden Seiten der Zentralachse Z gelegen sein. Bei der in den Figuren 37 bis 39 gezeigten Ausführungsform der Antriebsvorrichtung K4 sind zusätzlich die Längsrichtungen L401, L402 symmetrisch in Bezug auf die Zentralachse Z. Bei der gezeigten Ausführungsform der Antriebsvorrichtung K4 ist das Friktionselement F mittig auf der Zentralachse Z gelegen.

Die Antriebsvorrichtung K4 kann Merkmale der Antriebsvorrichtung K2 oder der Antriebsvorrichtung K3 und umgekehrt aufweisen. Auch können die in Bezug auf die Antriebsvorrichtung K2 und K3 vorgenommenen Definitionen auf eine andere hierin beschriebene Antriebsvorrichtung und insbesondere die Antriebsvorrichtung K4 Anwendung finden.

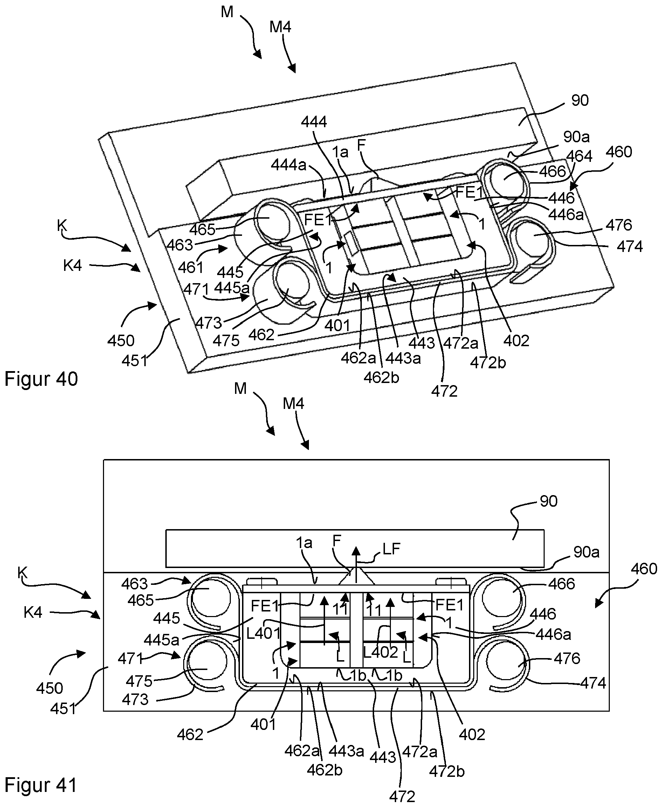

In den Figuren 40 und 41 ist ein Motor M4 dargestellt, in den die Antriebsvorrichtung K4 integriert oder eingebaut ist. Der Motor weist die Antriebsvorrichtung K4, eine Lagerungsvorrichtung 450 zur Lagerung der Antriebsvorrichtung K4, ein anzutreibendes Element 90 und eine Führungsvorrichtung zur Führung der Bewegung des anzutreibendes Elements 90 auf. Die Antriebsvorrichtung K1, die Antriebsvorrichtung K2 oder die Antriebsvorrichtung K3 oder beschriebene Varianten können jeweils auch in die Lagerungsvorrichtung 450 oder in beschriebene Varianten derselben gelagert oder integriert sein.

Die Lagerungsvorrichtung 450 ist als eine Grundplatte 451 ausgeführt, die insbesondere die Funktion einer Lagerungsplatte oder Verbindungsplatte haben kann. Die Antriebsvorrichtung K4 kann an einem Abschnitt, der in einem Abstand der Lagerungsvorrichtung 450 oder der Grundplatte 451zu dem Friktionselement F angeordnet oder gelagert sein. Dabei erstreckt sich das Friktionselement F mit seiner Längsrichtung LF in der Längsrichtung L oder entlang der Längsrichtung L des Aktors 1 hin zu der Friktionsfläche 90a des anzutreibenden Elements 90. Alternativ dazu kann vorgesehen sein, dass sich das Friktionselement F mit seiner Längsrichtung LF quer zur Längsrichtung L des Aktors 1 hin zu einer Friktionsfläche 90a des anzutreibenden Elements 90 erstreckt. Dabei kann das Friktionselement F auch zwischen dem Halteteil 444 und insbesondere der Innenfläche 444b des Halteteils 444 und dem Aktor 1 angeordnet sein.

Die in den Figuren 40 und 41 dargestellte Lagerungsvorrichtung 450 weist eine Vorspannvorrichtung 460 auf, welche die Antriebsvorrichtung K und damit das Friktionselement F mit einer definierten Kraft gegen das anzutreibende Element 90 drückt.

Die Vorspannvorrichtung 460 ist zwischen der Grundplatte 451 und der Antriebsvorrichtung K4 angeordnet und derart geformt, dass diese das Friktionselement F der Antriebsvorrichtung K4 an das anzutreibende Element 490 drückt. Die Vorspannvorrichtung 460 der Figur 40 weist ein erstes Federblatt 461 auf, das in einem Mittelabschnitt 462 u-förmig oder wannenförmig gestaltet ist. An einer ersten Außenfläche 462a des Mittelabschnitt 462 desselben liegen zumindest abschnittsweise die Außenflächen 445c, 446c des Verbindungsteils 445, 446 und eine Außenfläche 444c des Halteteils 444 an. Der Mittelabschnitt 462 kann aus federndem oder formsteifen Material gebildet sein. Das erste Federblatt 461 ist an der Grundplatte 451 gehalten und kann, wie in der Figur 40 gezeigt, mit gekrümmten Endabschnitten 463, 464, die vorzugsweise aus federndem Material sind und die sich auf zueinander entgegen gesetzt gelegenen Seiten des Mittelabschnitts 462 an dieses anschließen, an Halterungen 465, 466 der Grundplatte 451, die jeweils in Bezug auf die Zentralachse Z auf verschiedenen Seiten der Antriebsvorrichtung K4 gelegen sind, gehalten sein. Dabei verlaufen die Endabschnitte 463, 464 zumindest abschnittsweise in von der Zentralachse Z oder von den Längsrichtungen L401, L402 abweichenden Richtungen, um ein federndes Halten des ersten Federblatts 461 an der Grundplatte 451 mit der vorgenannten Bewegbarkeit vorzusehen. Insbesondere kann dabei, wie in der Figur 29 gezeigt, vorgesehen sein, dass die Endabschnitte 463, 464 jeweilige von der Grundplatte 451 abstehenden Halterungen 465, 466 zumindest teilweise umklammern, um die Haltefunktion bereitzustellen.

Weiterhin kann die Vorspannvorrichtung 460 der Figur 40 eine weitere Haltevorrichtung zum federnden Halten der Antriebsvorrichtung K4 oder des ersten Federblatts 461 und insbesondere das in der Figur 40 gezeigte zweite Federblatt 471 aufweisen. Dieses ist in einem Mittelabschnitt 472 U-förmig oder wannenförmig gestaltet. Der Mittelabschnitt 472 kann aus federndem oder formsteifen Material gebildet sein. Der Mittelabschnitt 472 weist eine Außenfläche 472a auf, an der eine zweite Außenfläche 462b des Mittelabschnitts 462 des ersten Federblatts 461, die entgegen gesetzt zu der ersten Außenfläche 462a desselben orientiert ist, zumindest abschnittsweise anliegt, so dass der Mittelabschnitt 462 an dem zweiten Mittelabschnitt 472 in einer Richtung entlang der Zentralachse Z oder entlang den Längsrichtungen L401, L402 bewegbar ist. Dadurch wird das erste Federblatt 461 an dem zweiten Federblatt 471 unter Vorsehen einer Bewegbarkeit des ersten Federblatts 461 entlang den vorgenannten Richtungen gehalten. Das zweite Federblatt 471 ist an der Grundplatte 451 gehalten und kann, wie in der Figur 40 gezeigt, mit gekrümmten Endabschnitten 473, 474 an Halterungen 475, 476 der Grundplatte 451, die jeweils in Bezug auf die Zentralachse Z auf verschiedenen Seiten der Antriebsvorrichtung K4 und außerhalb des Mittelabschnitts 462 des ersten Federblatts 461 gelegen sind, gehalten sein. Dabei verlaufen die Endabschnitte 473, 474 zumindest abschnittsweise in von der Zentralachse Z oder von den Längsrichtungen L401, L402 abweichenden Richtungen, um ein federndes Halten des zweiten Federblatts 471 und somit auch des ersten Federblatts 461 an der Grundplatte 451 mit der vorgenannten Bewegbarkeit vorzusehen. Insbesondere kann dabei, wie in der Figur 40 gezeigt, vorgesehen sein, dass die Endabschnitte 473, 474 jeweilige von der Grundplatte 451 abstehende Halterungen 475, 476 zumindest teilweise umklammern, um die Haltefunktion bereitzustellen.

Die Vorspannvorrichtung 460 kann auch auf andere Weise ausgeführt sein. Beispielsweise kann die Antriebsvorrichtung K4 in einer Ausnehmung der Grundplatte 461 formschlüssig aufgenommen und gelagert sein. Dabei kann vorgesehen sein, dass durch die Form der Ausnehmung eine Bewegbarkeit der Antriebsvorrichtung K4 relativ zur Grundplatte 461 gegeben ist, wobei zusätzlich zwischen der Ausnehmung und der Antriebsvorrichtung K4 eine Feder wirkt, die die Antriebsvorrichtung K4 an das anzutreibende Element 90 drückt.

Die Lagerungsvorrichtung 450 kann auch anders realisiert und z.B. als eine Befestigungsvorrichtung ausgeführt sein, so dass der Motor keine Vorspannvorrichtung aufweist. In dem Motor M mit einer Ausführungsform der Lagerungsvorrichtung 450 nach der Erfindung kann eine hierin beschriebene Ausführungsform des Aktors 1 eingebaut oder integriert sein.

Die Führungsvorrichtung ist an der Grundplatte 451 ausgebildet und stellt insbesondere eine Führungsbahn bereit, die quer zur Zentralachse Z oder zumindest einer der Längsrichtungen L401, L402 verläuft, so dass sich das anzutreibende Element 90 aufgrund der Verformungen des Aktors 1 und der Bewegung des Friktionselements F relativ zur Grundplatte 51 quer zur Zentralachse Z oder quer zu zumindest einer der Längsrichtungen L401, L402 bewegen kann.

Die Führungsvorrichtung ist insbesondere stationär relativ zur Lagerungsvorrichtung 450 als einem Referenzsystem angeordnet.

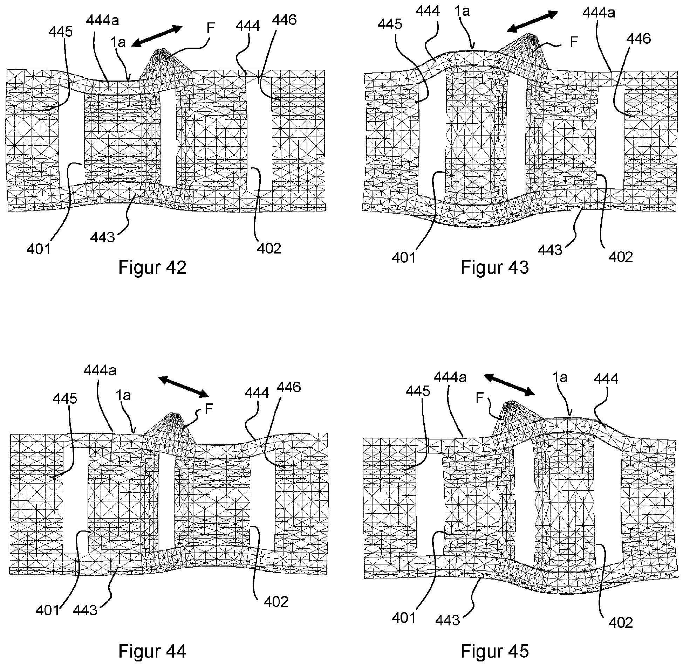

Die Figuren 42 bis 45 verdeutlichen anhand von FE-Simulationen die aufgrund unterschiedlicher elektrischer Ansteuerung der Aktoren der Antriebsvorrichtung K4 gemäß den Figuren 37 bis 39 erzeugbaren Deformationszustände der Antriebsvorrichtung.

Dabei ist ersichtlich, dass die Antriebsvorrichtung K4 bzw. dessen Friktionselement F ein anzutreibendes Element (in diesen Figuren nicht gezeigt) in zwei zueinander entgegen gesetzte Richtungen bewegen kann, insbesondere indem nur einer der beiden Aktoren 401 oder 402 wechselweise kontrahiert und expandiert wird. In der Figur 42 wird der Aktor 401 kontrahiert und in der Figur 43 wird der Aktor 401 expandiert. Bei abwechselndem Wiederholen dieser Betätigungen wird ein anzutreibendes Element mit der Bewegungskomponente in Richtung von dem Aktor 401 zum Aktor 402 bewegt. In der Figur 44 wird der Aktor 402 kontrahiert und in der Figur 45 wird der Aktor 402 expandiert. Bei abwechselndem Wiederholen dieser Betätigungen wird ein anzutreibendes Element mit der Bewegungskomponente in Richtung von dem Aktor 402 zum Aktor 401 bewegt.

### Bezugszeichen

- 1: Aktor
- 1a: äußere Aktuierungsfläche des ersten Ansteuerabschnitts A1
- 1b: Lagerungsfläche
- 5: Referenz-Elektrode
- 10: erste Außenfläche
- 11: erste Endfläche in der Längsrichtung L gesehen
- 12: zweite Endfläche
- 15: erste Ansteuerungs-Elektrode
- 16: erster Anschluss-Abschnitt der ersten Außenfläche 10
- 20: zweite Außenfläche
- 21: erste Endfläche
- 22: entgegen gesetzt zur ersten Endfläche 21 gelegene zweite Endfläche
- 25: zweite Ansteuerungs-Elektrode
- 26: zweiter Anschluss-Abschnitt der zweiten Außenfläche 20
- 30: dritte Außenfläche
- 31: erste Endfläche
- 32: zweite Endfläche
- 35: dritte Ansteuerungs-Elektrode
- 40: Halterungsvorrichtung
- 41: Spannrahmen
- 42: Lagereplatte
- 43: Aufnahmeteil
- 44: Halteteil
- 45, 46: Verbindungsteile
- 47: Aufnahmeraum
- 50: Lagerungsvorrichtung
- 51: Grundplatte
- 57: Ausnehmung der Grundplatte 51
- 60: Vorspannvorrichtung
- 64: Platte
- 65: erster Endabschnitt
- 66: zweiter Endabschnitt
- 90: anzutreibendes Element
- 90a: Friktionsfläche
- 95: Führungsvorrichtung
- 140: Halterungsvorrichtung
- 141: Spannrahmen
- 143: Aufnahmeteil
- 144: Halteteil
- 144a: Außenfläche des Halteteils 144
- 144b: Innenfläche des Halteteils 144
- 145, 146: Verbindungsteile
- 145a, 145b: Endabschnitte
- 145c, 146c: Außenflächen
- 145d, 146d: Verbindungselemente
- 147: erster Endabschnitt des Halteteils 144
- 148: zweiter Endabschnitt des Halteteils 144
- 149: Aufnahmeraum
- 240: Halterungsvorrichtung
- 241: Spannrahmen
- 243: Aufnahmeteil
- 244: Halteteil
- 244a: Außenfläche des Halteteils 244
- 244b: Innenfläche des Halteteils 244
- 245, 246: Verbindungsteile
- 245a, 245b: Endabschnitte
- 245c, 246c: Außenflächen
- 245d: Verbindungselement
- 247: erster Endabschnitt des Halteteils 144
- 248: zweiter Endabschnitt des Halteteils 144
- 249: Aufnahmeraum
- 401,402: Aktoren
- 440: Halterungsvorrichtung
- 443: Aufnahmeteil
- 444: Halteteil
- 444c: Außenfläche des Halteteils 444
- 445, 446: Verbindungsteil
- 445c, 446c: Außenflächen
- 445a: erster Endabschnitt
- 446a: zweiter Endabschnitt
- 447: Endabschnitt
- 448: Endabschnitt
- 449: Aufnahmeraum
- 450: Lagerungsvorrichtung
- 451: Grundplatte
- 460: Vorspannvorrichtung
- 461: erstes Federblatt
- 462: Mittelabschnitt
- 462a: erste Außenfläche des Mittelabschnitts 462
- 462b: zweite Außenfläche des Mittelabschnitts 462
- 463, 463: Endabschnitte
- 465, 466: Halterungen der Grundplatte 451
- 471: zweites Federblatt
- 472: Mittelabschnitt
- 472a: Außenfläche des Mittelabschnitts 472
- 473,474: Endabschnitte
- 475, 476: Halterungen der Grundplatte 451
- A1, A2, A3: Ansteuerabschnitte
- D1, D2, D3: Deformationskörper
- E1: Erreger-Elektrode
- E2: gemeinsame Elektrode
- F: Friktionselement
- FE1, FE2: Aktor-Endflächen
- V, V1, V2: Signalerzeugungs-Vorrichtungen
- G1, G2: Signalabschnitts-Gruppen
- K, K1, K2, K3, K4: Antriebsvorrichtungen
- L: Längsrichtung des Aktors 1
- L401, L402: Längsrichtung des Aktors 401 bzw. 402
- LF: Längsrichtung des Friktionselements F
- M, M1, M4: Motor
- S10: erstes Spannungssignal
- S11: ansteigende Signalflanke
- S12: Signalflanke
- S13: Zwischenabschnitt
- S20: zweites Spannungssignal
- S21: Signalabschnitt
- S22: Signalabschnitt
- SA1: erster Signalabschnitt
- SA2: zweiter Signalabschnitt
- t_{z}: Zeitintervall
- Z: Zentralachse

## Patentansprüche

1. Verfahren zum Betreiben eines elektromechanischen Elements, aufweisend folgende Schritte:
durch Ansteuern eines ersten durch eine elektrische Spannung deformierbaren Ansteuerabschnitts (A1) mit einem ersten Spannungssignal (S10) Erzeugung von Stellbewegungen eines an dem elektromechanischen Element angeordneten Friktionselements, das zu einem Friktionskontakt mit einem anzutreibenden Element (90) vorgesehen ist, wobei das erste Spannungssignal (S10) eine Mehrzahl von sich im zeitlichen Verlauf einander abwechselnden betragsmäßig ansteigenden Signalflanken (S11) und betragsmäßig abfallenden Signalflanken (S12) aufweist, wobei nach einer ansteigenden Signalflanke und vor einer darauf folgenden abfallenden Signalflanke, oder umgekehrt, ein Signal-Zwischenabschnitt (S13) mit einem von Null abweichenden Zeitintervall (t_{z} ) gelegen ist, der sich im zeitlichen Verlauf von der Form der Signalflanken unterscheidet und vorzugsweise eine zeitabhängige Steigung aufweist,
**gekennzeichnet, durch** Ansteuern eines zweiten durch eine elektrische Spannung deformierbaren Ansteuerabschnitts (A2) mit einem zweiten Spannungssignal (S20), der einen Signalabschnitt (S21) aufweist, dessen Frequenz im Vergleich zum ersten Spannungssignal (S10) um einen Faktor von wenigstens 10 größer ist und zeitlich innerhalb des Zeitintervalls t_{z} eines Signal-Zwischenabschnitts (S13) des ersten Spannungssignals (S10) beginnt und sich zumindest teilweise über die an diesen jeweils zeitlich anschließende Signalflanke (S12, S11) erstreckt.

2. Verfahren nach Anspruch 1, wobei der Signal-Zwischenabschnitt (S13) eine zeitabhängige Steigung aufweist, die betragsmäßig maximal 10 Grad beträgt.

3. Verfahren nach einem der vorhergehenden Ansprüche, wobei der Signalabschnitt (S21) des zweiten Spannungssignals (S20) beginnt, nachdem wenigstens 10% und maximal 90% des Zeitintervalls t_{z} des Signal-Zwischenabschnitts (S13) verstrichen sind oder 50% des Zeitintervalls vor Ende desselben.

4. Verfahren nach einem der vorhergehenden Ansprüche, wobei sich der Signalabschnitt (S21) des zweiten Spannungssignals (S20) bis in einen benachbarten und zeitlich nachfolgenden Signal-Zwischenabschnitt (S13) erstreckt und innerhalb dessen Zeitintervall t_{z} endet oder bis zu seinem Ende erstreckt.

5. Verfahren nach einem der vorhergehenden Ansprüche, wobei der Signalabschnitt (S21) des zweiten Spannungssignals (S20) sinusförmig ist.

6. Verfahren nach einem der vorhergehenden Ansprüche, wobei die maximale Amplitude des Signalabschnitts (S21) des zweiten Spannungssignals (S20) höchstens 50% der maximalen Amplitude des ersten Spannungssignals (S10) beträgt.

7. Verfahren nach einem der vorhergehenden Ansprüche,
wobei das Ansteuern des ersten Ansteuerabschnitts (A1) ein gleichzeitiges Ansteuern von mehreren ersten Ansteuer-Teilabschnitten, die den ersten Ansteuerabschnitt (A1) bilden und in der Längsrichtung (L) hintereinander gelegen sind, mit dem ersten Spannungssignal (S10) ist,
wobei das Ansteuern des zweiten Ansteuerabschnitts (A2) ein gleichzeitiges Ansteuern von mehreren zweiten Ansteuer-Teilabschnitten, die den zweiten Ansteuerabschnitt (A2) bilden und in der Längsrichtung (L) hintereinander gelegen sind, mit dem zweiten Spannungssignal (S20) ist.

8. Verfahren nach einem der vorhergehenden Ansprüche, wobei gleichzeitig mit der Ansteuerung des ersten Ansteuerabschnitts (A1) ein durch eine elektrische Spannung deformierbarer dritter Ansteuerabschnitt (A3) mit dem ersten Spannungssignal (S10) angesteuert wird, wobei der dritte Ansteuerabschnitt derart angeordnet ist, dass der zweite Ansteuerabschnitt (A2) zwischen dem ersten und dem dritten Ansteuerabschnitt (A3) gelegen ist.

9. Verfahren nach einem der vorhergehenden Ansprüche, wobei das Ansteuern des dritten Ansteuerabschnitts (A3) ein gleichzeitiges Ansteuern von mehreren dritten Ansteuer-Teilabschnitten, die den dritten Ansteuerabschnitt (A3) bilden und in der Längsrichtung hintereinander gelegen sind, mit dem ersten Spannungssignal (S10) ist.

10. Aktor (1), geeignet zur Anwendung des Verfahrens nach einem der vorhergehenden Ansprüche, aufweisend:
einen sich in einer Längsrichtung (L) erstreckenden und durch eine elektrische Spannung deformierbaren ersten Ansteuerabschnitt (A1), der aufweist: einen ersten Deformationskörper (D1), der durch eine erste Außenfläche (10) und zwei zueinander entgegen gesetzt gelegene Endflächen (11, 12), zwischen denen sich die erste Außenfläche (10) entlang der Längsrichtung erstreckt, umgrenzt ist, und zwei sich quer zur Längsrichtung erstreckende Aktuierungs-Elektroden (E1, E2), von denen eine als Erreger-Elektrode (E1) wirkende Aktuierungs-Elektrode an der ersten Endfläche (11) und eine als gemeinsame Elektrode (E2) wirkende Aktuierungs-Elektrode an der zweiten Endfläche (12) angeordnet ist,
einen sich in der Längsrichtung erstreckenden und durch eine elektrische Spannung deformierbaren zweiten Ansteuerabschnitt (A2), der aufweist: einen zweiten Deformationskörper (D2), der in der Längsrichtung (L) an dem ersten Deformationskörper (D1) angeordnet ist, der durch eine zweite Außenfläche (20) und zwei zueinander entgegen gesetzt gelegene Endflächen (21, 22), zwischen denen sich die zweite Außenfläche (20) entlang der Längsrichtung erstreckt, umgrenzt ist, und zwei sich quer zur Längsrichtung erstreckende Aktuierungs-Elektroden (E1, E2), von denen eine als Erreger-Elektrode (E1) wirkende Aktuierungs-Elektrode an der ersten Endfläche (21) und eine als gemeinsame Elektrode (E2) wirkende Aktuierungs-Elektrode an der zweiten Endfläche (22) angeordnet ist,
eine erste Ansteuerungs-Elektrode (15), die an einem ersten Anschluss-Abschnitt (16) der ersten Außenfläche (10) angeordnet ist und elektrisch mit der Erreger-Elektrode (E1) des ersten Ansteuerabschnitts (A1) verbunden ist,
eine zweite Ansteuerungs-Elektrode (25), die elektrisch von der ersten Ansteuerungs-Elektrode (15) getrennt ist, an einem zweiten Anschluss-Abschnitt (26) der zweiten Außenfläche (20) angeordnet ist und elektrisch mit der Erreger-Elektrode (E1) des zweiten Ansteuerabschnitts (A2) verbunden ist,
eine Referenz-Elektrode (5), die an der ersten Außenfläche (10) und der zweiten Außenfläche (20) und getrennt von der ersten Ansteuerungs-Elektrode (15) und getrennt von der zweiten Ansteuerungs-Elektrode (25) gelegen und elektrisch mit den gemeinsamen Elektroden (E2) des ersten und des zweiten Deformationskörpers (D1, D2) verbunden ist,
**dadurch gekennzeichnet, dass** ein Friktionselement (F) an einem in der Längsrichtung (L) orientierten Endabschnitt des ersten Ansteuerabschnitts (A1) oder des zweiten Ansteuerabschnitts (A2) angeordnet ist.

11. Aktor (1) nach dem Anspruch 10, wobei das Friktionselement (F) direkt an der ersten Endfläche (11) anliegt.

12. Aktor (1) nach dem Anspruch 10, wobei das Friktionselement (F) indirekt an der ersten Endfläche (11) anliegt, wobei zwischen der ersten Endfläche (11) und dem Friktionselement (F) eine Zwischenschicht oder eine Strukturkomponente mit einer Außenfläche als einer Aktuierungsfläche (1a) gelegen ist, die entlang der Orientierungsrichtung der ersten Endfläche (11) oder entlang der Längsrichtung L orientiert ist und die, bei Aktuierung des Aktors (1), eine Deformation der ersten Endfläche (11) aufnimmt und eine Positions- und Lage-Änderung des Friktionselements (F) bewirkt.

13. Aktor (1) nach einem der Ansprüche 10 bis 12, wobei der Aktor (1) weiterhin aufweist:
einen sich in einer Längsrichtung (L) erstreckenden und durch eine elektrische Spannung deformierbaren dritten Ansteuerabschnitt (A3), der an einer Seite des zweiten Ansteuerabschnitts (A2) gelegen ist, die in Bezug auf die Längsrichtung (L) entgegen gesetzt zu der Seite mit dem ersten Ansteuerabschnitt (A1) gelegen ist, und der aufweist: einen dritten Deformationskörper (D3), der durch eine dritte Außenfläche (30) und zwei zueinander entgegen gesetzt gelegene Endflächen (31, 32), zwischen denen sich die dritte Außenfläche (30) entlang der Längsrichtung (L) erstreckt, umgrenzt ist, und zwei sich quer zur Längsrichtung erstreckende Aktuierungs-Elektroden (E1, E2), von denen eine als Erreger-Elektrode (E1) wirkende Aktuierungs-Elektrode an der ersten Endfläche (31) und eine als gemeinsame Elektrode (E2) wirkende Aktuierungs-Elektrode an der zweiten Endfläche (32) angeordnet ist, und
eine dritte Ansteuerungs-Elektrode (35), die an einem dritten Anschluss-Abschnitt (36) der dritten Außenfläche (30) angeordnet ist und elektrisch mit der Erreger-Elektrode (E1) des dritten Ansteuerabschnitts (A3) verbunden ist,
wobei die Referenz-Elektrode zusätzlich an der dritten Außenfläche (30) des dritten Deformationskörpers (D3) und getrennt von der dritten Ansteuerungs-Elektrode (35) gelegen und elektrisch mit der gemeinsamen Elektrode (E2) des dritten Deformationskörpers (D3) verbunden ist.

14. Aktor (1) nach dem Anspruch 13, wobei die dritte Ansteuerungs-Elektrode (35) einteilig mit der ersten Ansteuerungs-Elektrode (15) gebildet ist.

15. Aktor (1) nach einem der Ansprüche 10 bis 14, wobei wenigstens einer der Ansteuerabschnitte (A1, A2, A3) aus einer Abfolge von mehreren Ansteuer-Teilabschnitten (A11, A12, A13, A21, A22, A23, A24, A31, A32, A33) gebildet ist, wobei jeder der Ansteuer-Teilabschnitte aus einer sich quer zur Längsrichtung erstreckenden plattenförmigen Erreger-Elektrode (E1), aus einer sich quer zur Längsrichtung erstreckenden plattenförmigen gemeinsamen Elektrode (E2) und einer in der Längsrichtung zwischen diesen gelegenen Schicht (P) aus einem elektromechanischen, insbesondere piezoelektrischen Material, wobei die Schicht (P) jeweils zwischen der Erreger-Elektrode (E1) und der gemeinsamen Elektrode (E2) gelegen ist, gebildet ist.

16. Aktor (1) nach einem der Ansprüche 10 bis 15, wobei wenigstens einer der Deformationskörper (D1, D2, D3), aus einem homogenen und elektrisch deformierbaren Material gebildet ist.

17. Antriebsvorrichtung (K) mit einem Aktor (1) nach einem der Ansprüche 10 bis 16 und einer wenigstens abschnittsweise elastisch ausgebildeten Halterungsvorrichtung (40), wobei der Aktor (1) in der Halterungsvorrichtung (40) gehalten und bevorzugt darin eingespannt ist.

18. Antriebsvorrichtung (K) nach Anspruch 17, wobei die Halterungsvorrichtung (40) als den Aktor (1) wenigstens abschnittsweise umfangenden Spannrahmen (41) ausgebildet ist.

19. Motor (M) mit einer Antriebsvorrichtung (K) nach einem der Ansprüche 17 oder 18 und einem anzutreibenden Element (90), das gegenüber der Antriebsvorrichtung (K) bewegbar gelagert ist und das sich mit dem Friktionselement (F) in einem Friktionskontakt befindet.

## Claims

1. Method for operating an electromechanical element, comprising the following steps:
by controlling a first control section (A1), which is deformable by an electrical voltage, with a first voltage signal (S10) generation of adjusting movements of a friction element which is arranged on the electromechanical element and which is provided for frictional contact with an element (90) to be driven, wherein the first voltage signal (S10) comprises a plurality of signal flanks (S11) which increase according to absolute amount and signal flanks (S12) which decrease according to absolute amount over time, wherein the increasing signal flanks and the decreasing signal flanks alternate with each other in terms of time, wherein after an increasing signal flank and before a subsequent decreasing signal flank, or vice versa, an intermediate signal section (S13) with a non-zero time interval (t_{z}) occurs, which differs over time from the shape of the signal flanks and preferably comprises a time-dependent gradient,
**characterized by** controlling of a second control section (A2) which is deformable by an electrical voltage by a second voltage signal (S20), which comprises a signal section (S21), the frequency of which compared to the first voltage signal (S10) is by a factor of at least 10 higher and which begins in terms of time within the time interval t_{z} of a signal intermediate section (S13) of the first voltage signal (S10) and extends at least partially over the signal flank (S12, S11) which in terms of time follows the signal intermediate section.

2. Method according to claim 1, wherein the signal intermediate section (S13) comprises a time-dependent gradient, which according to amount amounts to a maximum of 10 degrees.

3. Method according to one of the preceding claims, wherein the signal section (S21) of the second voltage signal (S20) begins after at least 10% and at most 90% of the time interval t_{z} of the signal intermediate section (S13) has passed or 50% of the time interval before the end of the same.

4. Method according to any one of the preceding claims, wherein the signal section (S21) of the second voltage signal (S20) extends into an adjacent and temporally subsequent signal intermediate section (S13) and ends within its time interval t_{z} or ends until its end.

5. Method according to one of the preceding claims, wherein the signal section (S21) of the second voltage signal (S20) is sinusoidal.

6. Method according to one of the preceding claims, wherein the maximum amplitude of the signal section (S21) of the second voltage signal (S20) is at most 50% of the maximum amplitude of the first voltage signal (S10).

7. Method according to one of the preceding claims,
wherein the control of the first control section (A1) is a simultaneous control of a plurality of first control sub-sections with the first voltage signal (S10), wherein the first control sub-sections form the first control section (A1) and are located one behind the other in the longitudinal direction (L),
wherein the control of the second control section (A2) is a simultaneous control of a plurality of second control sub-sections with the second voltage signal (S20), wherein the second control sub-sections form the second control section (A2) and are located one behind the other in the longitudinal direction (L).

8. Method according to one of the preceding claims, wherein, simultaneously with the control of the first control section (A1), a third control section (A3) which is deformable by an electrical voltage is controlled with the first voltage signal (S10), wherein the third control section is arranged such that the second control section (A2) is located between the first and the third control section (A3).

9. Method according to one of the preceding claims, wherein the control of the third control section (A3) is a simultaneous control of a plurality of third control sub-sections with the first voltage signal (S10), wherein the third control sub-sections form the third control section (A3) and are located one behind the other in the longitudinal direction.

10. Actor (1), suitable for using the method according to one of the preceding claims, comprising:
a first control section (A1) which extends in a longitudinal direction (L) and is deformable by an electrical voltage and comprises: a first deformation body (D1), which is delimited by a first outer surface (10) and two end faces (11, 12) which are lying opposite to each other and between which the first outer surface (10) extends along the longitudinal direction, and two actuation electrodes (E1, E2) which extend transversely to the longitudinal direction electrodes (E1, E2), wherein of the actuation electrodes one actuation electrode acts as an excitation electrode (E1) and is disposed at the first end face (11) and one actuation electrode acts as a common electrode (E2) and is disposed at the second end face (12),
a second control section (A2) which extends in a longitudinal direction (L) and is deformable by an electrical voltage and comprises: a second deformation body (D2), which is disposed in the longitudinal direction (L) at the first deformation body (D1), wherein the second deformation body (D2) is delimited by a second outer surface (20) and two end faces (21, 22) which are lying opposite to each other and between which the first outer surface (10) extends along the longitudinal direction, and two actuation electrodes (E1, E2) which extend transversely to the longitudinal direction electrodes (E1, E2), wherein of the actuation electrodes an actuation electrode acts as an excitation electrode (E1) and is disposed at the first end face (21) and an actuation electrode acts as a common electrode (E2) and is disposed at the second end face (22),
a first control electrode (15) which is disposed at a first connection section (16) of the first outer surface (10) and which is electrically connected to the excitation electrode (E1) of the first control section (A1),
a second control electrode (25), which is electrically separated from the first control electrode (15), which is disposed at a second connection section (26) of the second outer surface (20) and which is electrically connected to the excitation electrode (E1) of the second control section (A2),
a reference electrode (5) which is disposed on the first outer surface (10) and on the second outer surface (20) and disposed separated from the first control electrode (15) and separated from the second control electrode (25) and which is electrically connected to the common electrodes (E2) of the first and the second deformation body (D1, D2),
chraracterized in that a friction element (F) is disposed at an end section of the first control section (A1) or the second control section (A2), wherein the end section is oriented in the longitudinal direction (L).

11. Actor (1) according to claim 10, wherein the friction element (F) directly rests on the first end face (11).

12. Actor (1) according to claim 10, wherein the friction element (F) indirectly rests on the first end face (11), wherein between the first end face (11) and the friction element (F) an intermediate layer or a structural component with an outer surface as actuation surface (1a) is located, which is oriented along the orientation direction of the first end face (11) or along the longitudinal direction L and which receives a deformation of the first end face (11) and causes a change in position and location of the friction element (F).

13. Actor (1) according to one of the claims 10 to 12, wherein the actor (1) further comprises:
a third control section (A3) which extends in a longitudinal direction (L) and is deformable by an electrical voltage and which is located at a side of the second control section (A2), wherein this side is located opposite of the side with the first control section (A1) with respect to the longitudinal direction (L), and wherein the third control section (A3) comprises: a third deformation body (D3), which is delimited by a third outer surface (30) and two end faces (31, 32) which are lying opposite to each other and between which the third outer surface (30) extends along the longitudinal direction, and two actuation electrodes (E1, E2) which extend transversely to the longitudinal direction, of which actuation electrodes an actuation electrode acts as an excitation electrode (E1) and is disposed at the first end face (31) and an actuation electrode acts as a common electrode (E2) and is disposed at the second end face (32), and
a third control electrode (35) which is disposed at a third connection section (36) of the third outer surface (30) and which is electrically connected to the excitation electrode (E1) of the third control section (A3),
wherein the reference electrode is additionally disposed at the third outer surface (30) of the third deformation body (D3) and disposed separated from the third control electrode (35) and is electrically connected to the common electrode (E2) of the third deformation body (D3).

14. Actor (1) according to claim 13, wherein the third control electrode (35) is formed in one piece with the first control electrode (15).

15. Actor (1) according to one of claims 10 or 14, wherein at least one of the control sections (A1, A2, A3) is formed of a sequence of several control sub-sections (A11, A12, A13, A21, A22, A23, A24, A31, A32, A33), wherein each of the control sub-sections is formed of a plate-shaped excitation electrode (E1) which extends transversely to the longitudinal direction, of a plate-shaped common electrode (E2) which extends transversely to the longitudinal direction and of a layer (P) which is located between these in the longitudinal direction and which is made of an electromechanical, in particular piezoelectric material, wherein the layer (P) is respectively located between the excitation electrode (E1) and the common electrode (E2).

16. Actor (1) according to one of claims 10 to 15, wherein at least one of the deformation bodies (D1, D2, D3) is formed from a homogeneous and electrically deformable material.

17. Drive device (K) with an actor (1) according to one of claims 10 to 16 and a holding device (40) which is formed at least partially elastically, wherein the actor (1) is held in the holding device (40) and preferably clamped therein.

18. Drive device (K) according to claim 17, wherein the holding device (40) is realized as a tensioning frame (41) which surrounds the actor (1) at least in a section.

19. Motor (M) with a drive device (K) according to one of claims 17 or 18 and with an element (90) to be driven, which is supported so as to be movable relative to the drive device (K) and which is in frictional contact with a friction element (F) which is disposed at the actor (1).

## Revendications

1. Procédé opérationnel pour un élément électromécanique, comportant les étapes suivantes, consistant à :
par commande d'une première section de commande (A1) déformable par tension électrique, avec un premier signal de tension (S10), générer des mouvements de réglage d'un élément de friction placé sur l'élément électromécanique, qui est prévu pour un contact par friction avec un élément (90) qui doit être entraîné, le premier signal de tension (S10) comportant une multiplicité de fronts de signaux (S11) croissants en valeur et de fronts de signaux (S12) décroissants en valeur, s'alternant les uns les autres dans le temps, après un front de signal croissant et avant un front de signal décroissant consécutif à ce dernier ou inversement étant posée une section intermédiaire de signal (S13) avec un intervalle de temps (t_{z} ) différent de zéro, qui dans le temps diverge de la forme des fronts de signaux et présente de préférence une pente dépendant du temps,
**caractérisé par** la commande d'une deuxième section de commande (A2) déformable par tension électrique avec un deuxième signal de tension (S20), qui comporte une section de signal (S21) dont la fréquence est supérieure d'un coefficient d'au moins 10 en comparaison du premier signal de tension (S10) et qui commence dans le temps à l'intérieur de l'intervalle de temps t_{z} d'une section intermédiaire de signal (S13) du premier signal de tension (S10) et qui s'étend au moins partiellement sur le front de signal (S12, S11) qui se raccorde respectivement sur celui-ci dans le temps.

2. Procédé selon la revendication 1, la section intermédiaire de signal (S13) présentant une pente dépendant du temps, qui en valeur est d'un maximum de 10 degrés.

3. Procédé selon l'une quelconque des revendications précédentes, la section de signal (S21) du deuxième signal de tension (S20) commençant une fois qu'au moins 10 % et au maximum 90 % de l'intervalle de temps t_{z} de la section intermédiaire de signal (S13) se soient écoulés ou 50% de l'intervalle de temps avant la fin de celui-ci.

4. Procédé selon l'une quelconque des revendications précédentes, la section de signal (S21) du deuxième signal de tension (S20) s'étendant jusque dans une section intermédiaire de signal (S13) voisine et consécutive dans le temps et qui se termine à l'intérieur de son intervalle de temps t_{z} ou s'étendant jusqu'à sa fin.

5. Procédé selon l'une quelconque des revendications précédentes, la section de signal (S21) du deuxième signal de tension (S20) étant de forme sinusoïdale.

6. Procédé selon l'une quelconque des revendications précédentes, l'amplitude maximale de la section de signal (S21) du deuxième signal de tension (S20) s'élevant au maximum à 50 % de l'amplitude maximale du premier signal de tension (S10).

7. Procédé selon l'une quelconque des revendications précédentes,
la commande de la première section de commande (A1) étant une commande simultanée avec le premier signal de tension (S10) de plusieurs premières sections partielles de commande, qui constituent la première section de commande (A1) et qui se situent les unes derrière les autres dans la direction longitudinale (L) ,
la commande de la deuxième section de commande (A2) étant une commande simultanée avec le deuxième signal de tension (S20) de plusieurs deuxièmes sections partielles de commande, qui constituent la deuxième section de commande (A2) et qui se situent les unes derrière les autres dans la direction longitudinale (L) ,.

8. Procédé selon l'une quelconque des revendications précédentes, simultanément avec la commande de la première section de commande (A1), une troisième section de commande (A3) déformable par tension électrique étant commandée avec le premier signal de tension (S10), la troisième section de commande étant placée de telle sorte que la deuxième section de commande (A2) se situe entre le première et la troisième section de commande (A3).

9. Procédé selon l'une quelconque des revendications précédentes, la commande de la troisième section de commande (A3) étant une commande simultanée avec le premier signal de tension (S10) de plusieurs troisièmes sections partielles de commande, qui constituent la troisième section de commande (A3) et qui se situent les unes derrière les autres dans la direction longitudinale.

10. Actionneur (1), adapté à l'application du procédé selon l'une quelconque des revendications précédentes, comportant:
une première section de commande (A1) s'étendant dans la direction longitudinale (L) et déformable par tension électrique, laquelle comporte : un premier corps de déformation (D1), qui est délimité par une première surface extérieure (10) et deux surfaces d'extrémité (11, 12) situées mutuellement à l'opposée, à travers lesquelles la première surface extérieure (10) s'étend le long de la direction longitudinale, et deux électrodes d'actionnement (E1, E2) s'étendant à la transversale de la direction longitudinale, dont une électrode d'actionnement qui agit en tant qu'électrode d'excitation (E1) est placée sur la première surface d'extrémité (11) et une électrode d'actionnement agissant en tant qu'électrode commune (E2) est placée sur la deuxième surface d'extrémité (12),
une deuxième section de commande (A2), s'étendant dans la direction longitudinale et déformable par tension électrique, laquelle comporte : un deuxième corps de déformation (D2), qui dans la direction longitudinale (L) est placé sur le premier corps de déformation (D1), qui est délimité par une deuxième surface extérieure (20) et deux surfaces d'extrémité (21, 22), situées mutuellement à l'opposée, à travers lesquelles la deuxième surface extérieure (20) s'étend le long de la direction longitudinale, et deux électrodes d'actionnement (E1, E2) s'étendant à la transversale de la direction longitudinale, dont une électrode d'actionnement qui agit en tant qu'électrode d'excitation (E1) est placée sur la première surface d'extrémité (21) et une électrode d'actionnement agissant en tant qu'électrode commune (E2) est placée sur la deuxième surface d'extrémité (22),
une première électrode de commande (15), qui est placée sur une première section de raccordement (16) de la première surface extérieure (10) et qui est électriquement connectée avec l'électrode d'excitation (E1) de la première section de commande (A1),
une deuxième électrode de commande (25), qui est électriquement séparée de la première électrode de commande (15), est placée sur une deuxième section de raccordement (26) de la deuxième surface extérieure (20) et est électriquement connectée avec l'électrode d'excitation (E1) de la deuxième section de commande (A2),
une électrode de référence (5), qui se situe sur la première surface extérieure (10) et sur la deuxième surface extérieure (20) et séparément de la première électrode de commande (15) et séparément de la deuxième électrode de commande (25) et qui est électriquement connectée avec les électrodes (E2) communes du premier et du deuxième corps de déformation (D1, D2),
**caractérisé en ce qu'**un élément de friction (F) est placé sur une section d'extrémité orientée dans la direction longitudinale (L) de la première section de commande (A1) ou de la deuxième section de commande (A2).

11. Actionneur (1) selon la revendication 10, l'élément de friction (F) étant directement adjacent à la première surface d'extrémité (11).

12. Actionneur (1) selon la revendication 10, l'élément de friction (F) étant indirectement adjacent à la première surface d'extrémité (11), entre la première surface d'extrémité (11) et l'élément de friction (F) étant située une couche intermédiaire ou une composante de structure, pourvue d'une surface extérieure en tant qu'une surface d'activation (1a) qui est orientée le long de la direction d'orientation de la première surface d'extrémité (11) ou le long de la direction longitudinale L et qui, lors de l'activation de l'actionneur (1), absorbe une déformation de la première surface d'extrémité (11) et provoque une modification de position et d'emplacement de l'élément de friction (F).

13. Actionneur (1) selon l'une quelconque des revendications 10 à 12, l'actionneur (1) comportant par ailleurs :
une troisième section de commande (A3) s'étendant dans la direction longitudinale (L) et déformable par une tension électrique, qui se situe sur un côté de la deuxième section de commande (A2), qui en rapport à la direction longitudinale (L), se situe à l'opposée du côté pourvu de la première section de commande (A1) et qui comporte un troisième corps de déformation (D3), qui est délimité par une troisième surface extérieure (30) et par deux surfaces d'extrémité (31, 32) situées à l'opposée mutuelle l'une de l'autre, entre lesquelles la troisième surface extérieure (30) s'étend le long de la direction longitudinale (L) t, et deux électrodes d'actionnement (E1, E2) s'étendant à la transversale de la direction longitudinale, dont l'une électrode d'actionnement, faisant office d'électrode d'excitation (E1) est placée sur la première surface d'extrémité (31) et une électrode d'actionnement faisant office d'électrode commune (E2) est placée sur la deuxième surface d'extrémité (32) et
une troisième électrode de commande (35), qui est placée sur une troisième section de raccordement (36) de la troisième surface extérieure (30) et qui est électriquement connectée avec l'électrode d'excitation (E1) de la troisième section de commande (A3),
l'électrode de référence se situant additionnellement sur la troisième surface extérieure (30) du troisième corps de déformation (D3) et séparément de la troisième électrode de commande (35) et étant électriquement connectée avec l'électrode commune (E2) du troisième corps de déformation (D3).

14. Actionneur (1) selon la revendication 13, la troisième électrode de commande (35) étant conçue d'un seul tenant avec la première électrode de commande (15).

15. Actionneur (1) selon l'une quelconque des revendications 10 à 14, au moins l'une des sections de commande (A1, A2, A3) étant constituée d'une succession de plusieurs sections partielles de commande (A11, A12, A13, A21, A22, A23, A24, A31, A32, A33), chacune des sections partielles de commande étant constituée d'une électrode d'excitation (E1) en forme de plaque, s'étendant à la transversale de la direction longitudinale, d'une électrode commune (E2) s'étendant à la transversale de la direction longitudinale et d'une couche (P) d'une matière électromécanique), notamment piézoélectrique, située entre ses dernières dans la direction longitudinale, la couche (P) étant constituée respectivement entre l"électrode d'excitation (E1) et l'électrode commune (E2).

16. Actionneur (1) selon l'une quelconque des revendications 10 à 15, au moins l'un des corps de déformation (D1, D2, D3) étant constitué d'une matière homogène et électriquement déformable.

17. Dispositif d'entraînement (K) pourvu d'un actionneur (1) selon l'une quelconque des revendications 10 à 16 et d'un dispositif de maintien (40), conçu au moins par endroits de manière élastique, l'actionneur (1) étant maintenu dans le dispositif de maintien (40) et étant de préférence enserré dans celui-ci.

18. Dispositif d'entraînement (K) selon la revendication 17, le dispositif de maintien (40) étant conçu sous la forme d'un cadre de serrage (41) entourant l'actionneur (1) au moins par endroits.

19. Moteur (M), pourvu d'un dispositif d'entraînement (K) selon l'une quelconque des revendications 17 ou 18 et d'un élément (90) qui doit être entraîné, qui est logé en étant mobile par rapport au dispositif d'entraînement (K) et qui se trouve dans un contact par friction avec l'élément de friction (F).
